# EUROPÄISCHE PATENTSCHRIFT

(11) **EP 2 838 929 B1**
(45) Veröffentlichungstag und Bekanntmachung des Hinweises auf die Patenterteilung: **14.06.2023**
(21) Anmeldenummer: 13716209.5
(22) Anmeldetag: 15.04.2013
(51) Int. Cl.: H10K 85/10

(54) **POLYMERE ENTHALTEND SUBSTITUIERTE TRIARYLAMIN-EINHEITEN SOWIE ELEKTROLUMINESZENZVORRICHTUNGEN ENTHALTEND DIESE POLYMERE**
POLYMERS CONTAINING SUBSTITUTED TRIARYLAMINE UNITS AND ELECTROLUMINESCENT DEVICES CONTAINING SAID POLYMERS
POLYMÈRES CONTENANT DES MOTIFS TRIARYLAMINE SUBSTITUÉS ET DISPOSITIFS ÉLECTROLUMINESCENTS CONTENANT LESDITS POLYMÈRES

(30) Priorität: 17.04.2012 EP 12002655
(43) Veröffentlichungstag der Anmeldung: 25.02.2015
(73) Patentinhaber: Merck Patent GmbH, 64293 Darmstadt (DE)
(72) Erfinder: ECKES, Fabrice, 64293 Darmstadt (DE); STEGMAIER, Katja, 64285 Darmstadt (DE); HAYER, Anna, 55118 Mainz (DE); HEIL, Holger, 60389 Frankfurt am Main (DE); JOOSTEN, Dominik, 60487 Frankfurt am Main (DE)
(86) Internationale Anmeldenummer: PCT/EP2013/001096
(87) Internationale Veröffentlichungsnummer: WO 2013/156130

(56) Entgegenhaltungen:
- EP-A1- 1 724 294
- EP-A1- 1 892 258
- WO-A1-00/55927
- WO-A1-2005/056638
- WO-A1-2006/070184
- WO-A1-2013/156125
- JP-A- 2004 087 395

## Beschreibung

Die vorliegende Erfindung betrifft Polymere enthaltend substituierte Triarylamin-Wiederholungseinheiten, Verfahren zu deren Herstellung sowie deren Verwendung in elektronischen bzw. optoelektronischen Vorrichtungen, insbesondere in organischen Elektrolumineszenzvorrichtungen, sogenannten OLEDs (OLED = Organic Light Emitting Diodes). Darüber hinaus betrifft die vorliegende Erfindung auch organische Elektrolumineszenzvorrichtungen enthaltend diese Polymere.

In elektronischen bzw. optoelektronischen Vorrichtungen, insbesondere in organischen Elektrolumineszenzvorrichtungen (OLED) werden Komponenten verschiedener Funktionalität benötigt. In OLEDs liegen die verschiedenen Funktionalitäten dabei normalerweise in verschiedenen Schichten vor. Man spricht in diesem Fall von mehrschichtigen OLED-Systemen. Diese mehrschichtigen OLED-Systeme weisen dabei unter anderem ladungsinjizierende Schichten, wie z.B. elektronen- und lochinjizierende Schichten, ladungstransportierende Schichten, wie z.B. elektronen- und lochleitende Schichten, sowie Schichten auf, die lichtemittierende Komponenten enthalten. Diese mehrschichtigen OLED-Systeme werden in der Regel durch das aufeinanderfolgende schichtweise Aufbringen hergestellt.

Werden dabei mehrere Schichten aus Lösung aufgebracht, ist darauf zu achten, dass eine bereits aufgebrachte Schicht nach deren Trocknung nicht durch das nachfolgende Aufbringen der Lösung zur Herstellung der nächsten Schicht zerstört wird. Dies kann beispielsweise dadurch erreicht werden, dass eine Schicht unlöslich gemacht wird, beispielsweise durch Vernetzung. Solche Verfahren werden z.B. in der EP 0 637 899 und der WO 96/20253 offenbart.

Darüber hinaus ist es aber auch notwendig, die Funktionalitäten der einzelnen Schichten von der Materialseite her so aufeinander abzustimmen, dass möglichst gute Ergebnisse, z.B. hinsichtlich Lebensdauer, Effizienz, etc. erreicht werden. So haben insbesondere die Schichten, die direkt an eine emittierende Schicht angrenzen, insbesondere die lochtransportierende Schicht (HTL = Hole Transport Layer), einen signifikanten Einfluss auf die Eigenschaften der angrenzenden emittierenden Schicht.

In der JP 2004/087395 A werden Polymere offenbart, die trisubstituierte Amingruppen als Wiederholungseinheit aufweisen, die jeweils mit zwei Arylgruppen und einer Carbazolgruppe substituiert sind.

In der WO 00/055927 A1 werden Polymere mit Triarylamingruppen als Wiederholungseinheiten offenbart, bei denen jeweils die Arylgruppe, die nicht in der Hauptkette angeordnet ist, in der meta- oder para-Position substituiert ist.

In der WO 2006/070184 A1, in der EP 1724294 A1, in der EP 1892258 A1 und in der WO 2005/056638 A1 werden Polymere mit Triarylamineinheiten offenbart, die mit Alkylgruppen substituiert sind. Eine Offenbarung von Polymeren mit Triarylamineinheiten die in ortho-Position mit einem monooder polycyclischen, aromatischen oder heteroaromatischen Ringsystem mit 5 bis 60 aromatischen Ringatomen substituiert ist, kann den genannten Dokumenten nicht entnommen werden.

Eine der Aufgaben der vorliegenden Erfindung lag deshalb in der Bereitstellung von Verbindungen, die einerseits aus Lösung verarbeitet werden können und die andererseits bei der Verwendung in elektronischen bzw. opto-elektronischen Vorrichtungen, vorzugsweise in OLEDs, und hier insbesondere in deren Lochtransportschicht, zu einer Verbesserung der Eigenschaften der Vorrichtung, d.h. insbesondere der OLED, führen.

Überraschenderweise wurde gefunden, dass Polymere, welche Triarylamin-Wiederholungseinheiten aufweisen, von denen mindestens eine Arylgruppe in ortho-Position substituiert ist, insbesondere bei Verwendung in der lochtransportierenden Schicht von OLEDs zu einer deutlichen Erhöhung der Lebensdauer dieser OLEDs führen.

Gegenstand der vorliegenden Anmeldung ist somit ein Polymer, das mindestens eine Struktureinheit der folgenden Formel (la) aufweist: 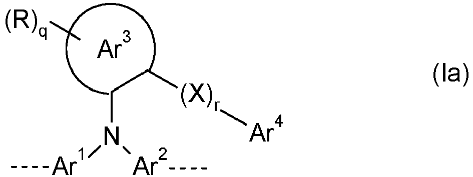 wobei
- Ar¹ und Ar²: bei jedem Auftreten, jeweils gleich oder verschieden, ein mono- oder polycyclisches, aromatisches oder heteroaromatisches Ringsystem mit 5 bis 60 aromatischen Ringatomen ist, das mit einem oder mehreren Resten R substituiert sein kann;
- Ar³: ein mono- oder polycyclisches, aromatisches Ringsystem mit 5 bis 60 aromatischen Ringatomen ist, das mit einem oder mehreren Resten R substituiert sein kann;
- R: bei jedem Auftreten gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein mono- oder polycyclisches, aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, oder eine vernetzbare Gruppe Q, wobei zwei oder mehrere Reste R auch miteinander ein mono- oder polycyclisches, aliphatisches, aromatisches und/oder benzoannelliertes Ringsystem bilden können;
- R¹: bei jedem Auftreten gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches oder aromatisches Ringsystem bilden können;
- q: 0, 1, 2, 3, 4, 5 oder 6, vorzugsweise 0, 1, 2, 3 oder 4, ist;
- X: CR₂, SiR₂, O, S, C=O oder P=O, vorzugsweise CR₂, NR, O oder S, ist;
- r: 0 oder 1, vorzugsweise 0, ist; und die gestrichelten Linien Bindungen zu benachbarten Struktureinheiten im Polymer darstellen;
dadurch gekennzeichnet, dass Ar³ in mindestens einer, vorzugsweise in einer der beiden ortho-Positionen, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann,
mit der Maßgabe, dass die Polymere P19a, P19b, P20a, P20b, P22a, P22b, P33a, P33b, P41a und P41b der WO 2013/156125 A1 ausgeschlossen sind.

Ar⁴ kann dabei entweder direkt, das heißt über eine Einfachbindung, mit Ar³ verknüpft sein oder aber über eine Verknüpfungsgruppe X.

In der vorliegenden Anmeldung sind unter dem Begriff Polymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 10 bis 5000 und ganz besonders bevorzugt 10 bis 2000 Struktureinheiten (d.h. Wiederholungseinheiten) auf. Die erfindungsgemäßen oligomeren Verbindungen weisen vorzugsweise 3 bis 9 Struktureinheiten auf. Der Verzweigungs-Faktor der Polymere liegt dabei zwischen 0 (lineares Polymer, ohne Verzweigungsstellen) und 1 (vollständig verzweigtes Dendrimer).

Die erfindungsgemäßen Polymere weisen vorzugsweise ein Molekulargewicht M_{w} im Bereich von 1.000 bis 2.000.000 g/mol, besonders bevorzugt ein Molekulargewicht M_{w} im Bereich von 10.000 bis 1.500.000 g/mol und ganz besonders bevorzugt ein Molekulargewicht M_{w} im Bereich von 50.000 bis 1.000.000 g/mol auf. Die Bestimmung des Molekulargewichts M_{w} erfolgt mittels GPC (= Gelpermeationschromatographie) gegen einen internen Polystyrolstandard.

Bei den erfindungsgemäßen Polymeren handelt es sich entweder um konjugierte, teilkonjugierte oder nicht-konjugierte Polymere. Bevorzugt sind konjugierte oder teilkonjugierte Polymere.

Die Struktureinheiten der Formel (la) können erfindungsgemäß in die Haupt- oder in die Seitenkette des Polymeren eingebaut werden. Vorzugsweise werden die Struktureinheiten der Formel (la) jedoch in die Hauptkette des Polymers eingebaut. Bei Einbau in die Seitenkette des Polymeren können die Struktureinheiten der Formel (la) entweder monooder bivalent sein, d.h. sie weisen entweder eine oder zwei Bindungen zu benachbarten Struktureinheiten im Polymer auf.

"Konjugierte Polymere" im Sinne der vorliegenden Anmeldung sind Polymere, die in der Hauptkette hauptsächlich sp²-hybridisierte (bzw. gegebenenfalls auch sp-hybridisierte) Kohlenstoffatome enthalten, die auch durch entsprechend hybridisierte Heteroatome ersetzt sein können. Dies bedeutet im einfachsten Fall abwechselndes Vorliegen von Doppel- und Einfachbindungen in der Hauptkette, aber auch Polymere mit Einheiten wie beispielsweise einem meta-verknüpften Phenylen sollen im Sinne dieser Anmeldung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Als konjugierte Polymere gelten ebenfalls Polymere mit einer konjugierten Hauptkette und nicht-konjugierten Seitenketten. Des Weiteren wird in der vorliegenden Anmeldung ebenfalls als konjugiert bezeichnet, wenn sich in der Hauptkette beispielsweise Arylamineinheiten, Arylphosphineinheiten, bestimmte Heterocyclen (d.h. Konjugation über N-, O- oder S-Atome) und/oder metallorganische Komplexe (d.h. Konjugation über das Metallatom) befinden. Analoges gilt für konjugierte Dendrimere. Hingegen werden Einheiten wie beispielsweise einfache Alkylbrücken, (Thio)Ether-, Ester-, Amid- oder Imidverknüpfungen eindeutig als nicht-konjugierte Segmente definiert.

Unter einem teilkonjugierten Polymer soll in der vorliegenden Anmeldung ein Polymer verstanden werden, das konjugierte Regionen enthält, die durch nicht-konjugierte Abschnitte, gezielte Konjugationsunterbrecher (z.B. Abstandsgruppen) oder Verzweigungen voneinander getrennt sind, z.B. in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält. Konjugierte und teilkonjugierte Polymere können auch konjugierte, teilkonjugierte oder nicht-konjugierte Dendrimere enthalten.

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

Unter dem Begriff "Struktureinheit" wird in der vorliegenden Anmeldung eine Einheit verstanden, die, ausgehend von einer Monomereinheit, die mindestens zwei, vorzugsweise zwei, reaktive Gruppen aufweist, durch Reaktion unter Verbindungsknüpfung als ein Teil des Polymergrundgerüstes in dieses eingebaut wird, und damit verknüpft im hergestellten Polymer als Wiederholungseinheit vorliegt.

Unter dem Begriff "mono- oder polycyclisches, aromatisches Ringsystem" wird in der vorliegenden Anmeldung ein aromatisches Ringsystem mit 6 bis 60, vorzugsweise 6 bis 30 und besonders bevorzugt 6 bis 24 aromatischen Ringatomen verstanden, das nicht notwendigerweise nur aromatische Gruppen enthält, sondern in dem auch mehrere aromatische Einheiten durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein können. So sollen beispielsweise auch Systeme wie z.B. 9,9'-Spirobifluoren, 9,9-Diarylfluoren und 9,9-Dialkylfluoren, als aromatische Ringsysteme verstanden werden. Die aromatischen Ringsysteme können mono- oder polycyclisch sein, d.h. sie können einen Ring (z.B. Phenyl) oder mehrere Ringe aufweisen, welche auch kondensiert (z.B. Naphthyl) oder kovalent verknüpft sein können (z.B. Biphenyl), oder eine Kombination von kondensierten und verknüpften Ringen enthalten.

Bevorzugte aromatische Ringsysteme sind z.B. Phenyl, Biphenyl, Terphenyl, [1,1':3',1"]Terphenyl-2'-yl, Quarterphenyl, Naphthyl, Anthracen, Binaphthyl, Phenanthren, Dihydrophenanthren, Pyren, Dihydropyren, Chrysen, Perylen, Tetracen, Pentacen, Benzpyren, Fluoren, Inden, Indenofluoren und Spirobifluoren.

Unter dem Begriff "mono- oder polycyclisches, heteroaromatisches Ringsystem" wird in der vorliegenden Anmeldung ein aromatisches Ringsystem mit 5 bis 60, vorzugsweise 5 bis 30 und besonders bevorzugt 5 bis 24 aromatischen Ringatomen verstanden, wobei ein oder mehrere dieser Atome ein Heteroatom ist/sind. Das "mono- oder polycyclische, heteroaromatische Ringsystem" enthält nicht notwendigerweise nur aromatische Gruppen, sondern kann auch durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein.

Die heteroaromatischen Ringsysteme können mono- oder polycyclisch sein, d.h. sie können einen Ring oder mehrere Ringe aufweisen, welche auch kondensiert oder kovalent verknüpft sein können (z.B. Pyridylphenyl), oder eine Kombination von kondensierten und verknüpften Ringen enthalten. Bevorzugt sind vollständig konjugierte Heteroarylgruppen.

Bevorzugte heteroaromatische Ringsysteme sind z.B. 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder Gruppen mit mehreren Ringen, wie Carbazol, Indenocarbazol, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen.

Das mono- oder polycyclische, aromatische oder heteroaromatische Ringsystem kann unsubstituiert oder substituiert sein. Substituiert heißt in der vorliegenden Anmeldung, dass das mono- oder polycyclische, aromatische oder heteroaromatische Ringsystem einen oder mehrere Substituenten R aufweist.

R ist bei jedem Auftreten vorzugsweise gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxyoder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, oder eine vernetzbare Gruppe Q; dabei können zwei oder mehrere Reste R auch miteinander ein mono- oder polycyclisches, aliphatisches, aromatisches und/oder benzoannelliertes Ringsystem bilden.

R ist bei jedem Auftreten besonders bevorzugt gleich oder verschieden H, D, F, Cl, Br, I, N(R¹)₂, Si(R¹)₃, B(OR¹)₂, C(=O)R¹, P(=O)(R¹)₂, eine geradkettige Alkyl- oder Alkoxygruppe mit 1 bis 20 C-Atomen oder eine Alkenyl- oder Alkinylgruppe mit 2 bis 20 C-Atomen oder eine verzweigte oder cyclische Alkyl- oder Alkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=NR¹, P(=O)(R¹), NR¹, O oder CONR¹ ersetzt sein können und wobei ein oder mehrere H-Atome durch F, Cl, Br oder I ersetzt sein können, oder ein aromatisches oder heteroaromatisches Ringsystem mit 5 bis 30 aromatischen Ringatomen, das jeweils durch einen oder mehrere Reste R¹ substituiert sein kann, oder eine Aryloxy- oder Heteroaryloxygruppe mit 5 bis 30 aromatischen Ringatomen, die durch einen oder mehrere Reste R¹ substituiert sein kann, oder eine Aralkyl- oder Heteroaralkylgruppe mit 5 bis 30 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann, oder eine vernetzbare Gruppe Q; dabei können zwei oder mehrere Reste R auch miteinander ein mono- oder polycyclisches, aliphatisches, aromatisches und/oder benzoannelliertes Ringsystem bilden.

R ist bei jedem Auftreten ganz besonders bevorzugt gleich oder verschieden H, eine geradkettige Alkyl- oder Alkoxygruppe mit 1 bis 10 C-Atomen oder eine Alkenyl- oder Alkinylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, wobei eine oder mehrere nicht benachbarte CH₂-Gruppen durch R¹C=CR¹, C=C, C=O, C=NR¹, NR¹, O oder CONR¹ ersetzt sein können, oder ein aromatisches oder heteroaromatisches Ringsystem mit 5 bis 20 aromatischen Ringatomen, das jeweils durch einen oder mehrere Reste R¹ substituiert sein kann, oder eine Aryloxy- oder Heteroaryloxygruppe mit 5 bis 20 aromatischen Ringatomen, die durch einen oder mehrere Reste R¹ substituiert sein kann, oder eine Aralkyl- oder Heteroaralkylgruppe mit 5 bis 20 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann, oder eine vernetzbare Gruppe Q; dabei können zwei oder mehrere Reste R auch miteinander ein mono- oder polycyclisches, aliphatisches, aromatisches und/oder benzoannelliertes Ringsystem bilden.

Bevorzugte Alkylgruppen mit 1 bis 10 C-Atomen sind in der folgenden Tabelle abgebildet:

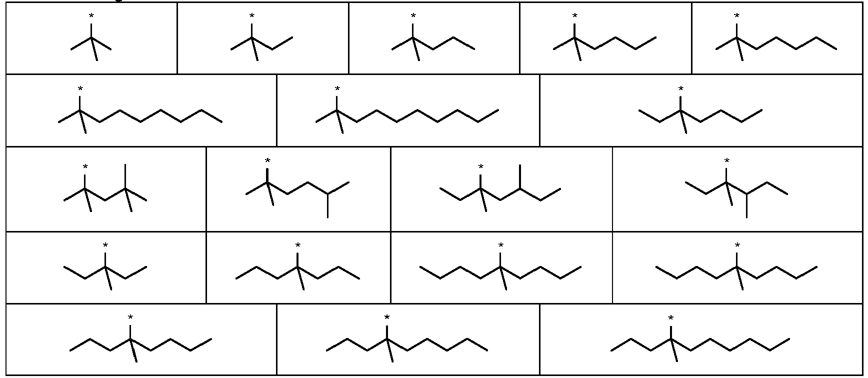

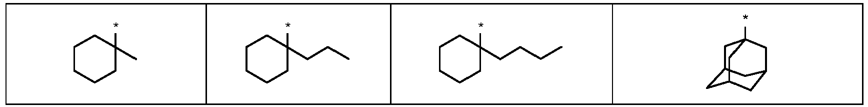

R¹ ist bei jedem Auftreten vorzugsweise gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen, in dem auch ein oder mehrere H-Atome durch F ersetzt sein können; dabei können zwei oder mehrere Substituenten R¹ auch miteinander ein mono- oder polycyclisches, aliphatisches oder aromatisches Ringsystem bilden.

R¹ ist bei jedem Auftreten besonders bevorzugt gleich oder verschieden H, D oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen; dabei können zwei oder mehrere Substituenten R¹ auch miteinander ein mono- oder polycyclisches, aliphatisches oder aromatisches Ringsystem bilden.

R¹ ist bei jedem Auftreten ganz besonders bevorzugt gleich oder verschieden H oder ein aliphatischer Kohlenwasserstoffrest mit 1 bis 10 C-Atomen, ein aromatischer und/oder ein heteroaromatischer Kohlenwasserstoffrest mit 5 bis 10 C-Atomen.

In einer zweiten Ausführungsform der vorliegenden Erfindung ist die mindestens eine Struktureinheit der Formel (la) des erfindungsgemäßen Polymeren dadurch gekennzeichnet, dass Ar³ in einer der beiden ortho-Positionen mit Ar⁴ substituiert ist, und Ar³ mit Ar⁴ zusätzlich noch in der zur substituierten ortho-Position benachbarten meta-Position verknüpft ist.

Die Struktureinheit der Formel (la) weist somit vorzugsweise die Struktur der folgenden Formel (Ib) auf: 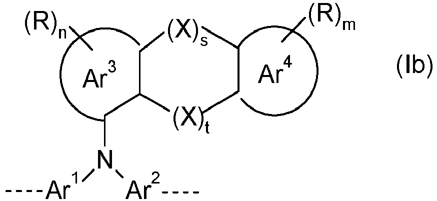
wobei Ar¹, Ar², Ar³, Ar⁴ und R die oben angegebenen Bedeutungen annehmen können,
m = 0, 1, 2, 3 oder 4 ist,
n = 0, 1, 2 oder 3 ist,
X = CR₂, SiR₂, O, S, C=O oder P=O, vorzugsweise CR₂, O oder S, ist, und s und t jeweils 0 oder 1 sind, wobei die Summe (s + t) = 1 oder 2, vorzugsweise 1 ist.

In einer bevorzugten Ausführungsform ist die mindestens eine Struktureinheit der Formel (la) ausgewählt aus den Struktureinheiten der folgenden Formeln (II), (III) und (IV): 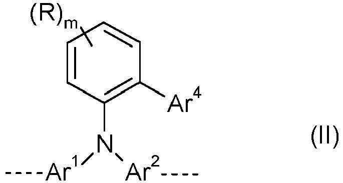 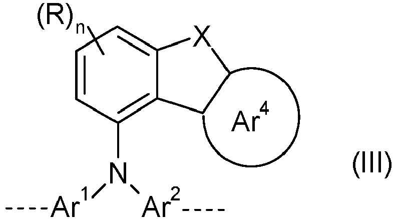 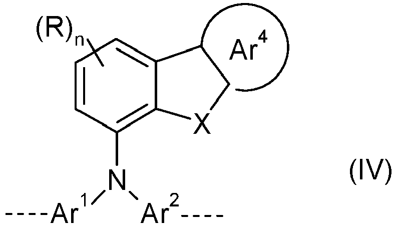
wobei Ar¹, Ar², Ar⁴ und R die oben angegebenen Bedeutungen annehmen können,
m = 0, 1, 2, 3 oder 4 ist,
n = 0, 1, 2 oder 3 ist, und
X = CR₂, SiR₂, O, S, C=O oder P=O, vorzugsweise CR₂, O oder S, ist.

In einer besonders bevorzugten Ausführungsform ist die mindestens eine Struktureinheit der Formel (II) ausgewählt aus der Struktureinheit der folgenden Formel (V): 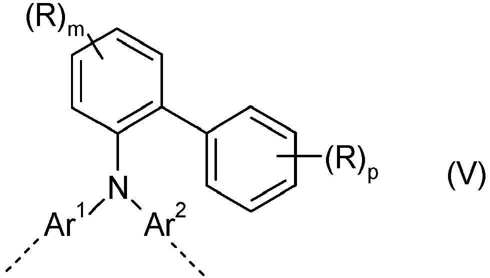
wobei Ar¹, Ar², R und m die oben angegebenen Bedeutungen annehmen können, und
p = 0, 1, 2, 3, 4 oder 5 ist.

Beispiele für bevorzugte Struktureinheiten der Formel (V) sind in der folgenden Tabelle abgebildet:

| | | |
|---|---|---|
| 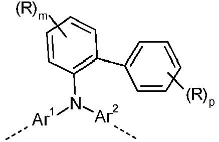 | 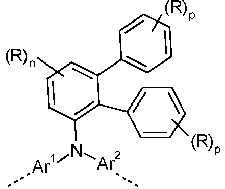 | 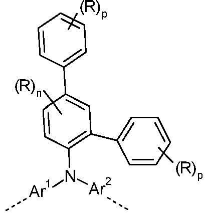 |
| (Va) | (Vb) | (Vc) |
| 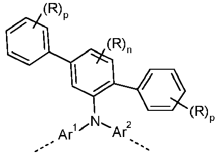 | 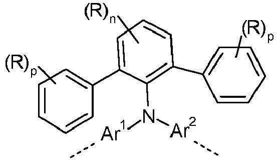 | 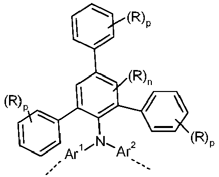 |
| (Vd) | (Ve) | (Vf) |
| 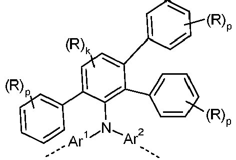 | 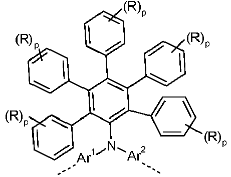 | |
| (Vg) | (Vh) | |

wobei Ar¹, Ar², R, m, n und p die oben angegebenen Bedeutungen annehmen können, und
k = 0, 1 oder 2 ist.

In einer weiteren besonders bevorzugten Ausführungsform ist die mindestens eine Struktureinheit der Formel (III) ausgewählt aus der Struktureinheit der folgenden Formel (VI): 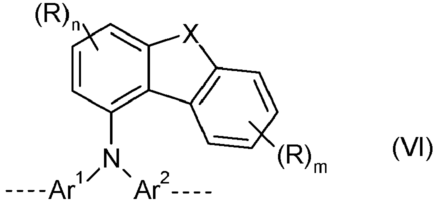 wobei Ar¹, Ar², R, X, m und n die oben angegebenen Bedeutungen annehmen können.

Beispiele für bevorzugte Struktureinheiten der Formel (VI) sind in der folgenden Tabelle abgebildet:

| | | |
|---|---|---|
| 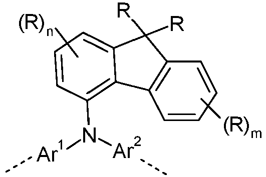 | 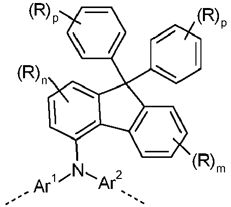 | 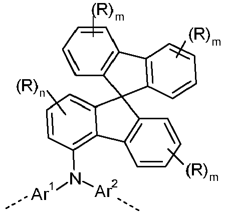 |
| (VIa) | (VIb) | (VIc) |
| | 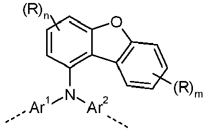 | 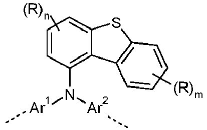 |
| | (VIe) | (VIf) |

wobei Ar¹, Ar², R, m, n und p die oben angegebenen Bedeutungen annehmen können.

In noch einer weiteren besonders bevorzugten Ausführungsform ist die mindestens eine Struktureinheit der Formel (IV) ausgewählt aus der Struktureinheit der folgenden Formel (VII): 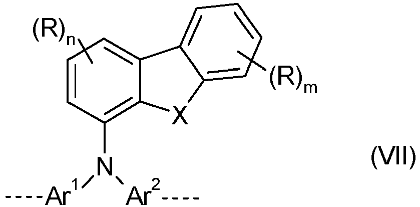 wobei Ar¹, Ar², R, X, m und n die oben angegebenen Bedeutungen annehmen können.

Beispiele für bevorzugte Struktureinheiten der Formel (VII) sind in der folgenden Tabelle abgebildet:

| | | |
|---|---|---|
| 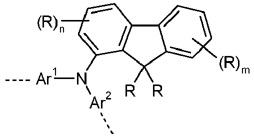 | 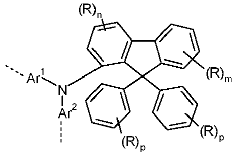 | 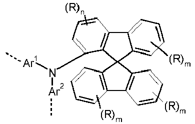 |
| (VIIa) | (VIIb) | (VIIc) |
| | 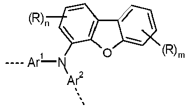 | 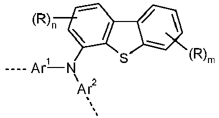 |
| | (VIIe) | (VIIf) |

wobei Ar¹, Ar², R, m, n und p die oben angegebenen Bedeutungen annehmen können.

In einer ganz besonders bevorzugten Ausführungsform ist die mindestens eine Struktureinheit der Formel (V) ausgewählt aus der Struktureinheit der folgenden Formel (VIII): 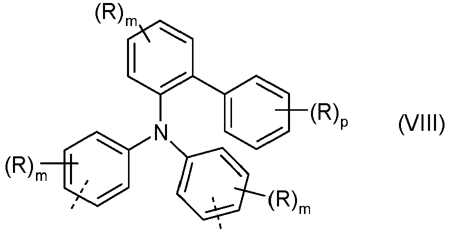 wobei R, m und p die oben angegebenen Bedeutungen annehmen können.

Beispiele für bevorzugte Struktureinheiten der Formel (VIII) sind in der folgenden Tabelle abgebildet:

| | |
|---|---|
| 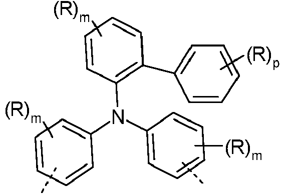 | 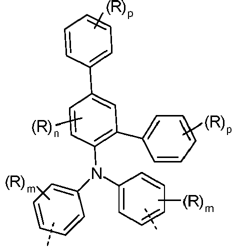 |
| (VIIIa) | (VIIIb) |
| 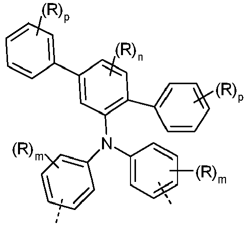 | 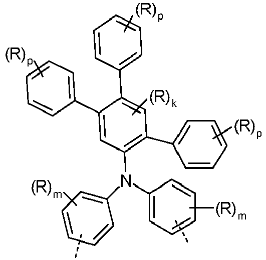 |
| (VIIIc) | (VIIId) |
| 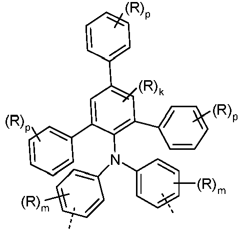 | 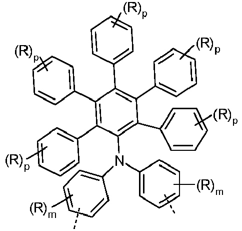 |
| (VIIIe) | (VIIIf) |
| 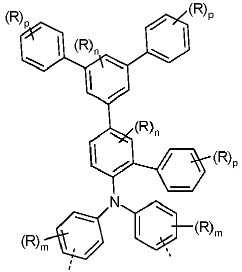 | 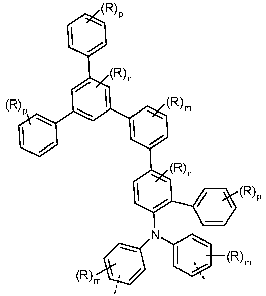 |
| (VIIIg) | (VIIIh) |

wobei R, k, m, n und p die oben angegebenen Bedeutungen annehmen können.

In einer weiteren ganz besonders bevorzugten Ausführungsform ist die mindestens eine Struktureinheit der Formel (VI) ausgewählt aus der Struktureinheit der folgenden Formel (IX): 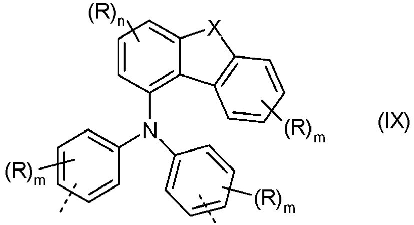 wobei R, X, m und n die oben angegebenen Bedeutungen annehmen können.

Beispiele für bevorzugte Struktureinheiten der Formel (IX) sind in der folgenden Tabelle abgebildet:

| | | |
|---|---|---|
| 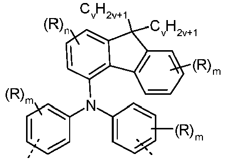 | 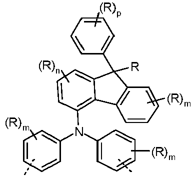 | |
| (IXa) | (IXb) | |
| 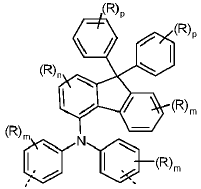 | 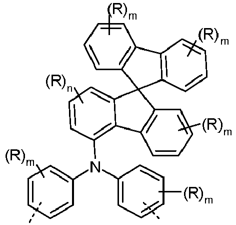 | |
| (IXc) | (IXd) | |
| | 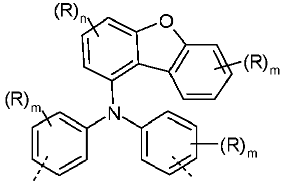 | 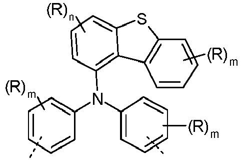 |
| | (IXf) | (IXq) |

wobei R, m, n und p die oben angegebenen Bedeutungen annehmen können, und
v = 1 bis 20, vorzugsweise 1 bis 10, ist.

In noch einer weiteren ganz besonders bevorzugten Ausführungsform ist die mindestens eine Struktureinheit der Formel (VII) ausgewählt aus der Struktureinheit der folgenden Formel (X): 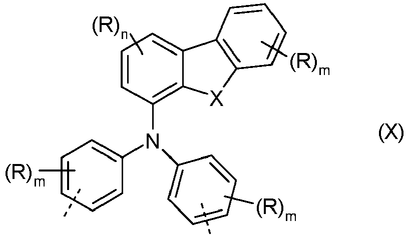 wobei R, X, m und n die oben angegebenen Bedeutungen annehmen können.

Beispiele für bevorzugte Struktureinheiten der Formel (X) sind in der folgenden Tabelle abgebildet:

| | | |
|---|---|---|
| 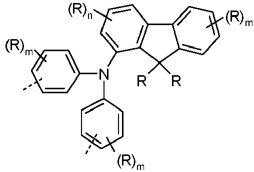 | 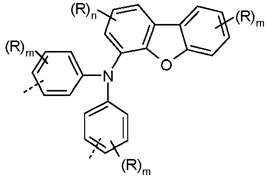 | 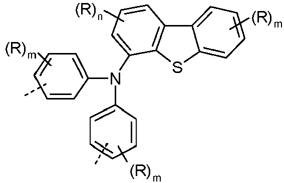 |
| (Xa) | (Xb) | (Xc) |

wobei R, m und n die oben angegebenen Bedeutungen annehmen können.

In den Formeln (VIII), (IX) und (X), sowie deren bevorzugten Ausführungsformen der Formeln (Vllla) bis (VIIIh), (IXa) bis (IXg) und (Xa) bis (Xc), stellen die gestrichelten Linien die Bindungen zu den benachbarten Struktureinheiten im Polymer dar. Sie können dabei unabhängig voneinander, gleich oder verschieden, in ortho-, meta- oder para-Position angeordnet sein, vorzugsweise gleich in ortho-, meta- oder para-Position, besonders bevorzugt in meta- oder para-Position und ganz besonders bevorzugt in para-Position.

Der Anteil an Struktureinheiten der Formel (la), (II), (III), (IV), (V), (VI), (VII), (VIII), (IX) oder (X) im Polymer liegt im Bereich von 1 bis 100 mol%.

In einer ersten bevorzugten Ausführungsform enthält das erfindungsgemäße Polymer nur eine Struktureinheit der Formel (la), (II), (III), (IV), (V), (VI), (VII), (VIII), (IX) oder (X), d.h. deren Anteil im Polymer beträgt 100 mol%. Es handelt sich in diesem Fall bei dem erfindungsgemäßen Polymer um ein Homopolymer.

In einer zweiten bevorzugten Ausführungsform liegt der Anteil an Struktureinheiten der Formel (la), (II), (III), (IV), (V), (VI), (VII), (VIII), (IX) oder (X) im Polymer im Bereich von 50 bis 95 mol%, besonders bevorzugt im Bereich von 60 bis 95 mol%, bezogen auf 100 mol% aller copolymerisierbaren Monomere, die im Polymer als Struktureinheiten enthalten sind, d.h., dass das erfindungsgemäße Polymer neben einer oder mehrerer Struktureinheiten der Formel (la), (II), (III), (IV), (V), (VI), (VII), (VIII), (IX) und/oder (X) noch weitere, von den Struktureinheiten der Formeln (la), (II), (III), (IV), (V), (VI), (VII), (VIII), (IX) und (X) verschiedene Struktureinheiten aufweist.

In einer dritten bevorzugten Ausführungsform liegt der Anteil an Struktureinheiten der Formel (la), (II), (III), (IV), (V), (VI), (VII), (VIII), (IX) oder (X) im Polymer im Bereich von 5 bis 50 mol%, besonders bevorzugt im Bereich von 25 bis 50 mol%, bezogen auf 100 mol% aller copolymerisierbaren Monomere, die im Polymer als Struktureinheiten enthalten sind, d.h., dass das erfindungsgemäße Polymer neben einer oder mehrerer Struktureinheiten der Formel (la), (II), (III), (IV), (V), (VI), (VII), (VIII), (IX) und/oder (X) noch weitere, von den Struktureinheiten der Formeln (la), (II), (III), (IV), (V), (VI), (VII), (VIII), (IX) und (X) verschiedene Struktureinheiten aufweist.

Diese, von den Struktureinheiten der Formeln (la), (II), (III), (IV), (V), (VI), (VII), (VIII), (IX) und (X) verschiedene Struktureinheiten, sind unter anderem solche, wie sie in der WO 02/077060 A1 und in der WO 2005/014689 A2 offenbart und umfangreich aufgelistet sind. Diese werden via Zitat als Bestandteil der vorliegenden Erfindung betrachtet. Die weiteren Struktureinheiten können beispielsweise aus den folgenden Klassen stammen:

| | |
|---|---|
| Gruppe 1: | Einheiten, welche die Lochinjektions- und/oder Lochtransporteigenschaften der Polymere beeinflussen; |
| Gruppe 2: | Einheiten, welche die Elektroneninjektions- und/oder Elektronentransporteigenschaften der Polymere beeinflussen; |
| Gruppe 3: | Einheiten, die Kombinationen von Einzeleinheiten der Gruppe 1 und Gruppe 2 aufweisen; |
| Gruppe 4: | Einheiten, welche die Emissionscharakteristik insoweit verändern, dass Elektrophosphoreszenz statt Elektrofluoreszenz erhalten werden kann; |
| Gruppe 5: | Einheiten, welche den Übergang vom Singulett- zum Triplettzustand verbessern; |
| Gruppe 6: | Einheiten, welche die Emissionsfarbe der resultierenden Polymere beeinflussen; |
| Gruppe 7: | Einheiten, welche typischerweise als Polymergrundgerüst (Backbone) verwendet werden; |
| Gruppe 8: | Einheiten, welche die Filmmorphologie und/oder die rheologischen Eigenschaften der resultierenden Polymere beeinflussen. |

Bevorzugte erfindungsgemäße Polymere sind solche, bei denen mindestens eine Struktureinheit Ladungstransporteigenschaften aufweist, d.h. die Einheiten aus der Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen.

Bevorzugte Struktureinheiten aus der Gruppe 1 sind die Struktureinheiten der folgenden Formeln (1a) bis (1q):

| | | |
|---|---|---|
| 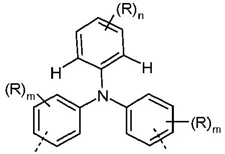 | 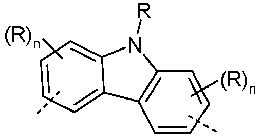 | |
| (1a) | (1b) | |
| 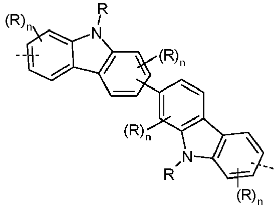 | 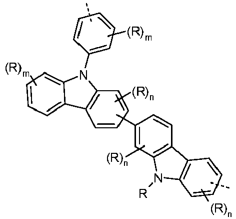 | 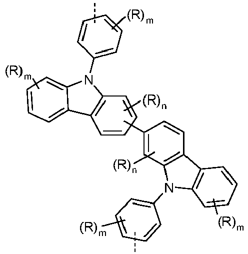 |
| (1c) | (1d) | (1e) |
| 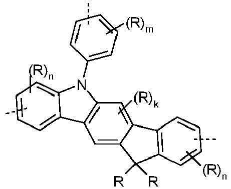 | 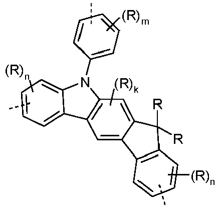 | |
| (1f) | (1q) | |
| 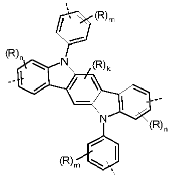 | 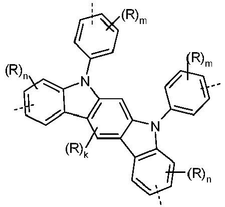 | |
| (1h) | (1i) | |
| 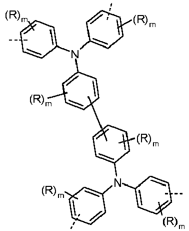 | 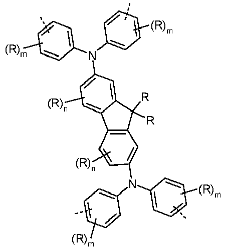 | 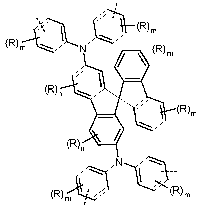 |
| (1i) | (1k) | (1m) |
| 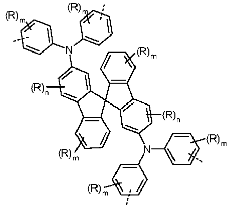 | 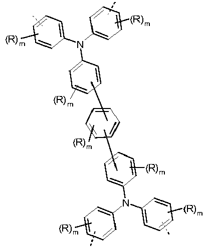 | 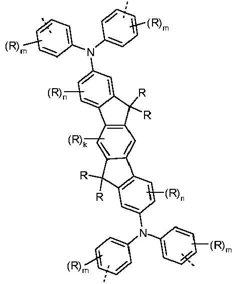 |
| (1n) | (1p) | (1q) |

wobei R, k, m und n die oben angegebenen Bedeutungen annehmen können.

In den Formeln (1a) bis (1q) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf. Sofern in den Formeln drei gestrichelte Linien vorhanden sind, weist die Struktureinheit ein, zwei oder drei, vorzugsweise zwei, Bindungen zu benachbarten Struktureinheiten auf. Sofern in den Formeln vier gestrichelte Linien vorhanden sind, weist die Struktureinheit ein, zwei, drei oder vier, vorzugsweise zwei, Bindungen zu benachbarten Struktureinheiten auf. Sie können dabei unabhängig voneinander, gleich oder verschieden, in ortho-, meta- oder para-Position angeordnet sein.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o. g. Bedingung erfüllen. Besonders bevorzugt sind hier entsprechende Struktureinheiten, welche Elemente der Gruppen 8 bis 10 (Ru, Os, Rh, Ir, Pd, Pt) enthalten. Als Struktureinheiten für die erfindungsgemäßen Polymere kommen hier z.B. verschiedene Komplexe in Frage, wie sie z.B. in der WO 02/068435 A1, der WO 02/081488 A1, der EP 1239526 A2 und der WO 2004/026886 A2 beschrieben werden. Entsprechende Monomere werden in der WO 02/068435 A1 und in der WO 2005/042548 A1 beschrieben.

Struktureinheiten der Gruppe 5 sind solche, welche den Übergang vom Singulett- zum Triplettzustand verbessern und welche, unterstützend zu den Strukturelementen der Gruppe 4 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Struktureinheiten der Gruppe 6 sind neben den oben genannten solche, die mindestens noch eine weitere aromatische oder eine andere konjugierte Struktur aufweisen, welche nicht unter die o. g. Gruppen fallen, d. h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilbenoder Bisstyrylarylenderivate, die jeweils mit einem oder mehreren Resten R substituiert sein können. Besonders bevorzugt ist dabei der Einbau von 1,4oder 9,10-Anthrylen-, 1,6-, 2,7- oder 4,9-Pyrenylen-, 3,9- oder 3,10-Perylenylen-, 4,4'-Tolanylen-, 4,4'-Stilbenylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9`-Spirobifluorenderivate, Phenanthrenderivate, 9,10-Dihydrophenanthrenderivate, 5,7-Dihydrodibenzooxepinderivate und cis- und trans-Indenofluorenderivate aber auch 1,2-, 1,3- oder 1,4-Phenylen-, 1,2-, 1,3oder 1,4-Naphthylen-, 2,2`-, 3,3`- oder 4,4'-Biphenylylen-, 2,2"-, 3,3"- oder 4,4"-Terphenylylen, 2,2`-, 3,3`- oder 4,4'-Bi-1,1'-naphthylylen- oder 2,2"`-, 3,3"`- oder 4,4'"-Quarterphenylylenderivate.

Bevorzugte Struktureinheiten aus der Gruppe 7 sind die Struktureinheiten der folgenden Formeln (7a) bis (7o):

| | | |
|---|---|---|
| 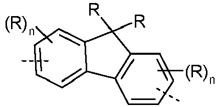 | 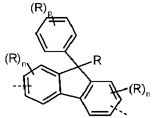 | 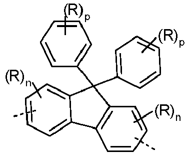 |
| (7a) | (7b) | (7c) |
| 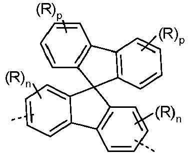 | 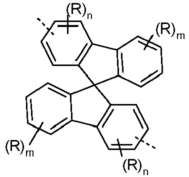 | |
| (7d) | (7e) | |
| 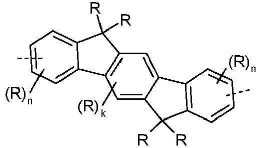 | 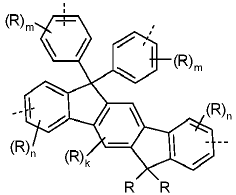 | 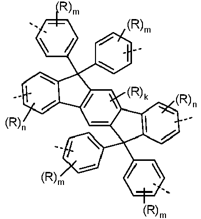 |
| (7f) | (7q) | (7h) |
| 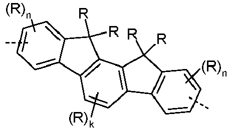 | 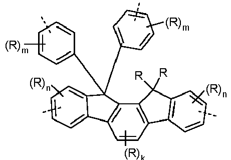 | |
| (7i) | (7i) | |
| 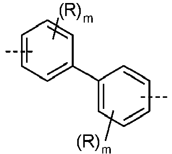 | 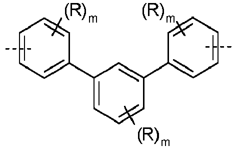 | |
| (7k) | (7m) | |
| 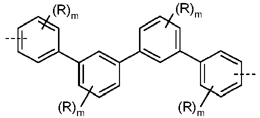 | 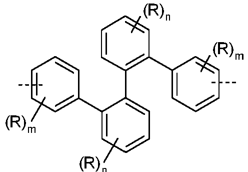 | |
| (7n) | (7o) | |

wobei R, k, m, n und p die oben angegebenen Bedeutungen annehmen können.

In den Formeln (7a) bis (7o) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf. Sofern in den Formeln vier oder mehr gestrichelte Linien vorhanden sind (Formeln (7g), (7h) und (7j)), weisen die Struktureinheiten ein, zwei, drei oder vier, vorzugsweise zwei, Bindungen zu benachbarten Struktureinheiten auf. Sie können dabei unabhängig voneinander, gleich oder verschieden, in ortho-, meta- oder para-Position angeordnet sein.

Struktureinheiten der Gruppe 8 sind solche, die die Filmmorphologie und/oder die rheologischen Eigenschaften der Polymere beeinflussen, wie z.B. Siloxane, Alkylketten oder fluorierte Gruppen, aber auch besonders steife oder flexible Einheiten, flüssigkristallbildende Einheiten oder vernetzbare Gruppen.

Bevorzugt sind erfindungsgemäße Polymere, die gleichzeitig neben Struktureinheiten der Formel (la), (II), (III), (IV), (V), (VI), (VII), (VIII), (IX) und/oder (X) zusätzlich noch ein oder mehrere Einheiten ausgewählt aus den Gruppen 1 bis 8 enthalten. Es kann ebenfalls bevorzugt sein, wenn gleichzeitig mehr als eine weitere Struktureinheit aus einer Gruppe vorliegt.

Bevorzugt sind dabei erfindungsgemäße Polymere, die neben mindestens einer Struktureinheit der Formel (la), (II), (III), (IV), (V), (VI), (VII), (VIII), (IX) und/oder (X) noch Einheiten aus der Gruppe 7 enthalten.

Ebenfalls bevorzugt ist es, wenn die erfindungsgemäßen Polymere Einheiten enthalten, die den Ladungstransport oder die Ladungsinjektion verbessern, also Einheiten aus der Gruppe 1 und/oder 2.

Besonders bevorzugt ist es weiterhin, wenn die erfindungsgemäßen Polymere Struktureinheiten aus der Gruppe 7 und Einheiten aus der Gruppe 1 und/oder 2 enthalten.

Die erfindungsgemäßen Polymere sind entweder Homopolymere aus Struktureinheiten der Formel (la), (II), (III), (IV), (V), (VI), (VII), (VIII), (IX) oder (X) oder Copolymere. Die erfindungsgemäßen Polymere können linear oder verzweigt sein, vorzugsweise linear. Erfindungsgemäße Copolymere können dabei neben einer oder mehreren Struktureinheiten der Formel (la), (II), (III), (IV), (V), (VI), (VII), (VIII), (IX) und/oder (X) potentiell eine oder mehrere weitere Strukturen aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Besonders bevorzugt weisen die erfindungsgemäßen Copolymere statistische oder alternierende Strukturen auf. Besonders bevorzugt sind die Copolymere statistische oder alternierende Copolymere. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Diese ist via Zitat Bestandteil der vorliegenden Anmeldung. Ebenso sei an dieser Stelle nochmals hervorgehoben, dass das Polymer auch dendritische Strukturen haben kann.

In einer weiteren Ausführungsform der vorliegenden Erfindung enthalten die erfindungsgemäßen Polymere neben einer oder mehrerer Struktureinheiten der Formel (la), (II), (III), (IV), (V), (VI), (VII), (VIII), (IX) und/oder (X) sowie gegebenenfalls weiteren Struktureinheiten ausgewählt aus den oben genannten Gruppen 1 bis 8 noch mindestens eine, vorzugsweise eine Struktureinheit, die eine vernetzbare Gruppe Q aufweist.

"Vernetzbare Gruppe Q" im Sinne der vorliegenden Erfindung bedeutet eine funktionelle Gruppe, die in der Lage ist, eine Reaktion einzugehen und so eine unlösliche Verbindung zu bilden. Die Reaktion kann dabei mit einer weiteren, gleichen Gruppe Q, einer weiteren, verschiedenen Gruppe Q oder einem beliebigen anderen Teil derselben oder einer anderen Polymerkette erfolgen. Bei der vernetzbaren Gruppe handelt es sich somit um eine reaktive Gruppe. Dabei erhält man als Ergebnis der Reaktion der vernetzbaren Gruppe eine entsprechend vernetzte Verbindung. Die chemische Reaktion kann auch in der Schicht durchgeführt werden, wobei eine unlösliche Schicht entsteht. Die Vernetzung kann gewöhnlich durch Wärme oder durch UV-, Mikrowellen-, Röntgen- oder Elektronenstrahlung unterstützt werden, gegebenenfalls in Gegenwart eines Initiators. "Unlöslich" im Sinne der vorliegenden Erfindung bedeutet vorzugsweise, dass das erfindungsgemäße Polymer nach der Vernetzungsreaktion, also nach der Reaktion der vernetzbaren Gruppen, bei Raumtemperatur in einem organischen Lösungsmittel eine Löslichkeit aufweist, die mindestens einen Faktor 3, vorzugsweise mindestens einen Faktor 10, geringer ist als die des entsprechenden, nicht-vernetzten, erfindungsgemäßen Polymers in demselben organischen Lösungsmittel.

Die Struktureinheit, die die vernetzbare Gruppe Q trägt, kann dabei in einer ersten Ausführungsform ausgewählt werden aus den Struktureinheiten der Formel (la), (II), (III), (IV), (V), (VI), (VII), (VIII), (IX) und/oder (X).

Bevorzugte Struktureinheiten, die die vernetzbare Gruppe Q tragen, sind die folgenden, aus der Struktureinheit der Formel (la) abgeleiteten Struktureinheiten der Formeln (Xla1) bis (XIa3): 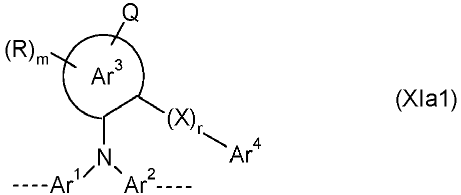 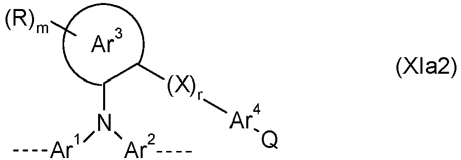 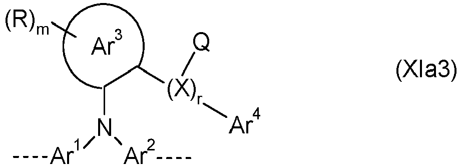 wobei Ar¹, Ar², Ar³, Ar⁴, R, m, X und r die oben in Bezug auf Formel (la) angegebenen Bedeutungen annehmen können.

Beispiele für bevorzugte Struktureinheiten der Formel (XIa) sind in der folgenden Tabelle abgebildet:

| | | |
|---|---|---|
| 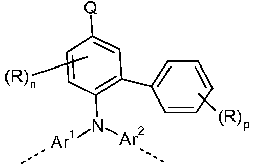 | 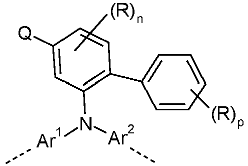 | 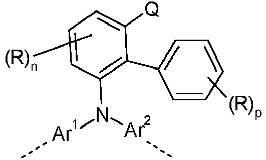 |
| (11a) | (11b) | (11c) |
| 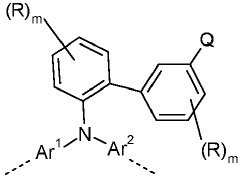 | 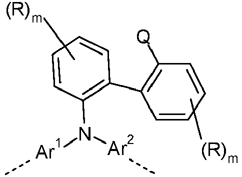 | 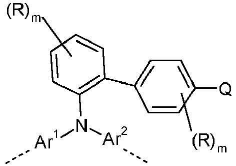 |
| (11d) | (11e) | (11f) |

wobei R, k, m, n und p die oben angegebenen Bedeutungen annehmen können.

In den Formeln (11a) bis (11f) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf.

Weitere bevorzugte Struktureinheiten, die die vernetzbare Gruppe Q tragen, sind die folgenden, aus der Struktureinheit der Formel (Ib) abgeleitetehn Struktureinheiten der Formeln (Xlb1) bis (XI1b4): 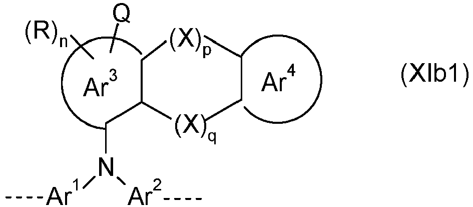 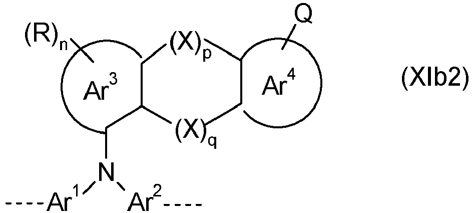 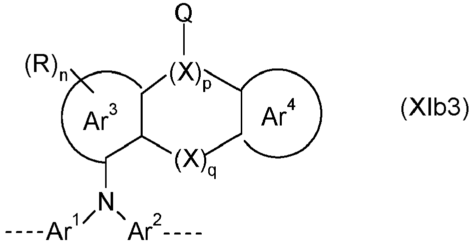 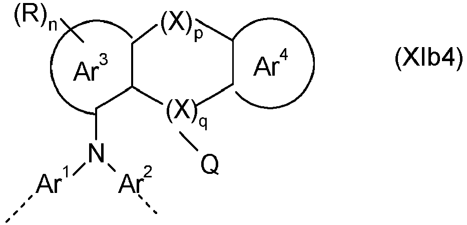 wobei Ar¹, Ar², Ar³, Ar⁴, R n, X, p und q die oben in Bezug auf Formel (Ib) angegebenen Bedeutungen annehmen können.

Beispiele für bevorzugte Struktureinheiten der Formel (XIb) sind in der folgenden Tabelle abgebildet:

| | | |
|---|---|---|
| 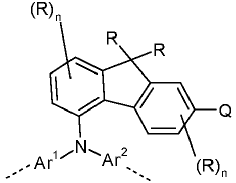 | 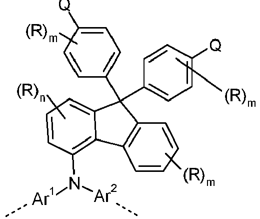 | 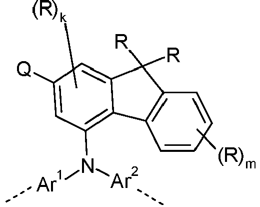 |
| (11g) | (11h) | (11i) |
| 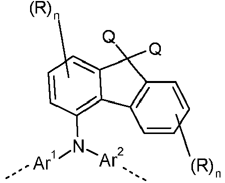 | 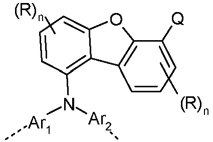 | 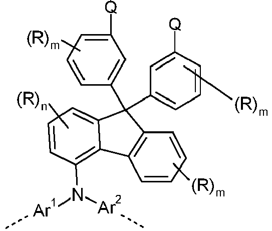 |
| (11j) | (11k) | (11l) |
| 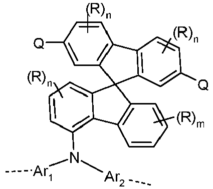 | 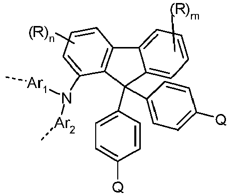 | 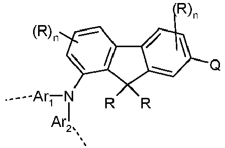 |
| (11m) | (11n) | (11o) |

wobei R, k, m, n und p die oben angegebenen Bedeutungen annehmen können.

In den Formeln (11g) bis (11o) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf.

Desweiteren kann die Struktureinheit, die die vernetzbare Gruppe Q trägt, in einer zweiten Ausführungsform ausgewählt werden aus den in den Gruppen 1 bis 8 offenbarten Struktureinheiten.

Eine bevorzugte Struktureinheit, die die vernetzbare Gruppe Q tragen, ist die folgende, aus den Triarylamineinheiten der Gruppe 1 abgeleitete Struktureinheit der Formel (XII): 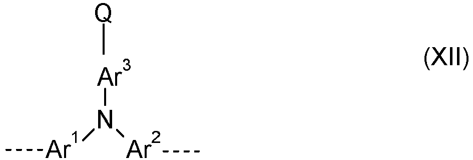 wobei Ar¹, Ar² und Ar³ die oben in Bezug auf Formel (la) angegebenen Bedeutungen annehmen können.

Beispiele für bevorzugte Struktureinheiten der Formel (XII) sind in der folgenden Tabelle abgebildet:

| | | |
|---|---|---|
| 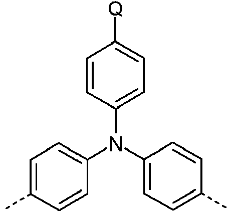 | 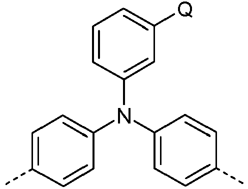 | |
| (12a) | (12b) | |

Eine weitere bevorzugte Struktureinheit, die die vernetzbare Gruppe Q tragen, ist die folgende, aus der Gruppe 7 abgeleitete Struktureinheit der Formel (XIII): 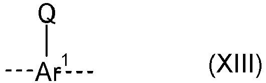 wobei Ar¹ die in Bezug auf die Struktureinheit der Formel (la) angegebenen Bedeutungen annehmen kann.

Beispiele für bevorzugte Struktureinheiten der Formel (XIII) sind in der folgenden Tabelle abgebildet:

| | | |
|---|---|---|
| 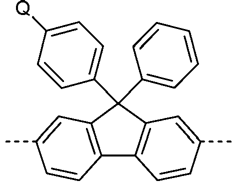 | 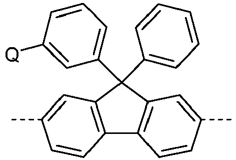 | 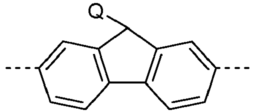 |
| (13a) | (13b) | (13c) |
| 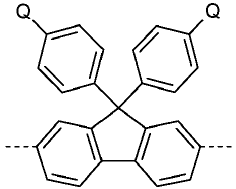 | 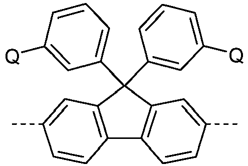 | 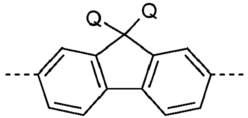 |
| (13d) | (13e) | (13f) |

Wie oben beschrieben, handelt es sich bei der vernetzbaren Gruppe Q um eine funktionelle Gruppe, die in der Lage ist, eine chemische Reaktion einzugehen und so eine unlösliche polymere Verbindung zu bilden. Es können generell alle Gruppen Q eingesetzt werden, die dem Fachmann für diesen Zweck bekannt sind. Es ist insbesondere die Aufgabe dieser Gruppe, durch eine Vernetzungsreaktion die erfindungsgemäßen polymeren Verbindungen, gegebenenfalls mit weiteren reaktiven polymeren Verbindungen, miteinander zu verknüpfen. Dies führt zu einer vernetzten Verbindung, bzw., wenn die Reaktion in einer Schicht durchgeführt wird, zu einer vernetzten Schicht. Unter einer vernetzten Schicht im Sinne der vorliegenden Erfindung wird eine Schicht verstanden, die erhältlich ist durch Durchführung der Vernetzungsreaktion aus einer Schicht der erfindungsgemäßen, vernetzbaren, polymeren Verbindung. Die Vernetzungsreaktion kann im Allgemeinen durch Wärme und/oder durch UV-, Mikrowellen-, Röntgen- oder Elektronenstrahlung und/oder durch den Einsatz von Radikalbildnern, Anionen, Kationen, Säuren und/oder Photosäuren initiiert werden. Ebenso kann die Anwesenheit von Katalysatoren sinnvoll oder notwendig sein. Bevorzugt ist die Vernetzungsreaktion eine Reaktion, für die kein Initiator und kein Katalysator zugesetzt werden muss.

Erfindungsgemäß bevorzugte vernetzbare Gruppen Q sind die im Folgenden aufgeführten Gruppen:
a) Endständige oder cyclische Alkenyl- bzw. endständige Dienyl- und Alkinylgruppen:
   Geeignet sind Einheiten, die eine endständige oder cyclische Doppelbindung, eine endständige Dienylgruppe oder eine endständige Dreifachbindung enthalten, insbesondere endständige oder cyclische Alkenyl-, endständige Dienyl- bzw. endständige Alkinylgruppen mit 2 bis 40 C-Atomen, vorzugsweise mit 2 bis 10 C-Atomen, wobei auch einzelne CH₂-Gruppen und/oder einzelne H-Atome durch die oben genannten Gruppen R ersetzt sein können. Weiterhin eignen sich auch Gruppen, die als Vorstufen zu betrachten sind und die in situ zu einer Bildung einer Doppel- oder Dreifachbindung in der Lage sind.
b) Alkenyloxy-, Dienyloxy- bzw. Alkinyloxygruppen:
   Weiterhin geeignet sind Alkenyloxy-, Dienyloxy- bzw. Alkinyloxygruppen, vorzugsweise Alkenyloxygruppen.
c) Acrylsäuregruppen:
   Weiterhin geeignet sind Acrylsäureeinheiten im weitesten Sinne, vorzugsweise Acrylester, Acrylamide, Methacrylester und Methacrylamide. Besonders bevorzugt sind C₁₋₁₀-Alkylacrylat und C₁₋₁₀-Alkylmethacrylat.
   Die Vernetzungsreaktion der oben unter a) bis c) genannten Gruppen kann über einen radikalischen, einen kationischen oder einen anionischen Mechanismus aber auch über Cycloaddition erfolgen.
   Es kann sinnvoll sein, einen entsprechenden Initiator für die Vernetzungsreaktion zuzugeben. Geeignete Initiatoren für die radikalische Vernetzung sind beispielsweise Dibenzoylperoxid, AIBN oder TEMPO. Geeignete Initiatoren für die kationische Vernetzung sind beispielsweise AlCl₃, BF₃, Triphenylmethylperchlorat oder Tropyliumhexachlorantimonat. Geeignete Initiatoren für die anionische Vernetzung sind Basen, insbesondere Butyllithium.
   In einer bevorzugten Ausführungsform der vorliegenden Erfindung wird die Vernetzung jedoch ohne den Zusatz eines Initiators durchgeführt und ausschließlich thermisch initiiert. Diese Bevorzugung wird dadurch begründet, dass die Abwesenheit des Initiators Verunreinigungen der Schicht verhindert, die zu einer Verschlechterung der Deviceeigenschaften führen könnten.
d) Oxetane und Oxirane:
   Eine weitere geeignete Klasse vernetzbarer Gruppen Q sind Oxetane und Oxirane, die durch Ringöffnung kationisch vernetzen.
   Es kann sinnvoll sein, einen entsprechenden Initiator für die Vernetzungs-reaktion zuzugeben. Geeignete Initiatoren sind beispielsweise AlCl₃, BF₃, Triphenylmethylperchlorat oder Tropyliumhexachlorantimonat. Ebenso können Photosäuren als Initiatoren zugegeben werden.
e) Silane:
   Weiterhin geeignet als Klasse vernetzbarer Gruppen sind Silangruppen SiR₃, wobei mindestens zwei Gruppen R, bevorzugt alle drei Gruppen R für Cl oder eine Alkoxygruppe mit 1 bis 20 C-Atomen stehen.
   Diese Gruppe reagiert in der Anwesenheit von Wasser zu einem Oligooder Polysiloxan.
f) Cyclobutangruppen
   Die oben genannten vernetzbaren Gruppen Q sind dem Fachmann generell bekannt, ebenso wie die geeigneten Reaktionsbedingungen, die zur Reaktion dieser Gruppen verwendet werden.

Bevorzugte vernetzbare Gruppen Q umfassen Alkenylgruppen der folgenden Formel Q1, Dienylgruppen der folgenden Formel Q2, Alkinylgruppen der folgenden Formel Q3, Alkenyloxygruppen der folgenden Formel Q4, Dienyloxygruppen der folgenden Formeln Q5, Alkinyloxygruppen der folgenden Formel Q6, Acrylsäuregruppen der folgenden Formeln Q7 und Q8, Oxetangruppen der folgenden Formeln Q9 und Q10, Oxirangruppen der folgenden Formel Q 11 und Cyclobutangruppen der folgenden Formel Q12:

| | |
|---|---|
| 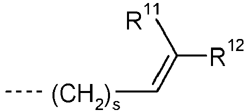 | 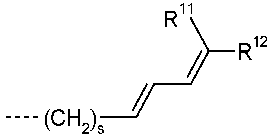 |
| Q1 | Q2 |
| 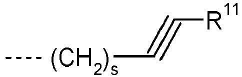 | 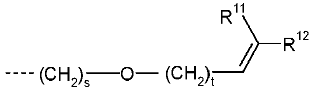 |
| Q3 | Q4 |
| 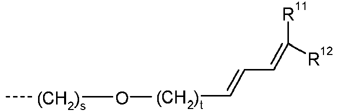 | 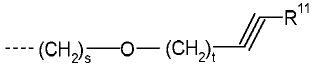 |
| Q5 | Q6 |
| 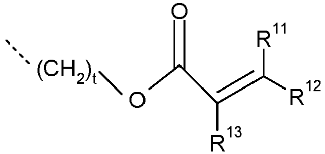 | 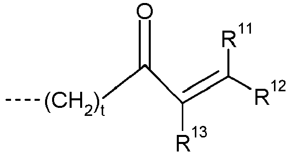 |
| Q7 | Q8 |
| 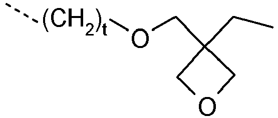 | 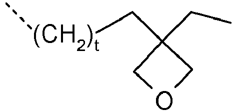 |
| Q9 | Q10 |
| 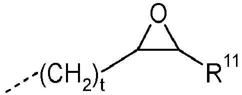 | 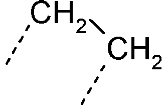 |
| Q11 | Q12 |

Die Reste R¹¹, R¹² und R¹³ in den Formeln Q1 bis Q8 und Q11 sind bei jedem Auftreten, gleich oder verschieden, H, eine geradkettige oder verzweigte Alkylgruppe mit 1 bis 6 C-Atomen, vorzugsweise 1 bis 4 C-Atomen. Besonders bevorzugt sind die Reste R¹¹, R¹² und R¹³ H, Methyl, Ethyl, n-Propyl, iso-Propyl, n-Butyl, sec-Butyl oder tert-Butyl und ganz besonders bevorzugt H oder Methyl. Die verwendeten Indices haben die folgende Bedeutung: s = 0 bis 8; und t = 1 bis 8.

Die gestrichelte Bindung in den Formeln Q1 bis Q11 sowie die gestrichelten Bindungen in der Formel Q12 stellen die Anknüpfung der vernetzbaren Gruppe an die Struktureinheiten dar.

Die vernetzbaren Gruppen der Formeln Q1 bis Q12 können dabei direkt mit der Struktureinheit verknüpft sein, oder aber indirekt, über ein weiteres, mono- oder polycyclisches, aromatisches oder heteroaromatisches Ringsystem Ar¹⁰, wie in den folgenden Formeln Q13 bis Q24 dargestellt:

| | |
|---|---|
| 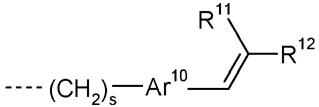 | 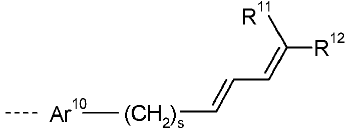 |
| Q13 | Q14 |
| 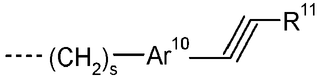 | 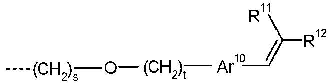 |
| Q15 | Q16 |
| 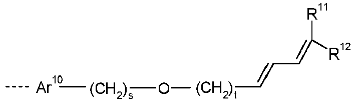 | 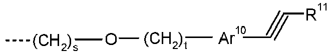 |
| Q17 | Q18 |
| 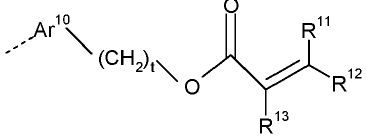 | 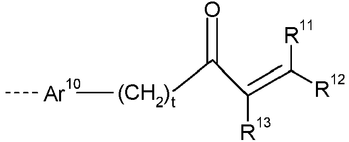 |
| Q19 | Q20 |
| 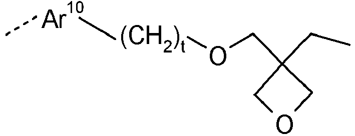 | 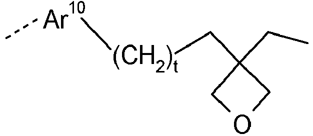 |
| Q21 | Q22 |
| 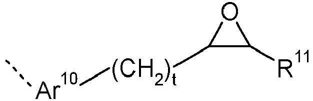 | 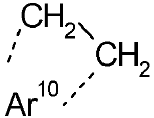 |
| Q23 | Q24 |

wobei Ar¹⁰ in den Formeln Q13 bis Q24 die gleichen Bedeutungen annehmen kann wie Ar¹.

Besonders bevorzugte vernetzbare Gruppen Q sind die folgenden:

| | |
|---|---|
| 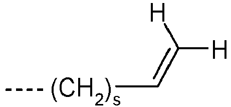 | 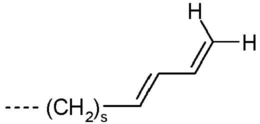 |
| Q1a | Q2a |
| 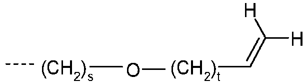 | 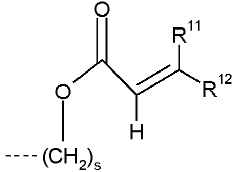 |
| Q4a | Q7a |
| 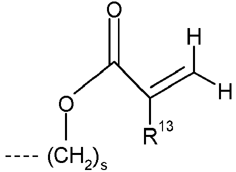 | 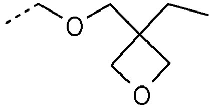 |
| Q7b | Q9a |
| 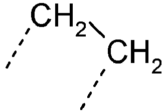 | 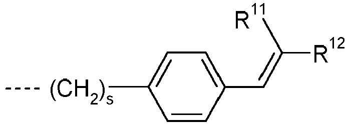 |
| Q12a | Q13a |
| 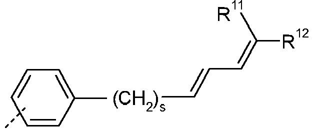 | 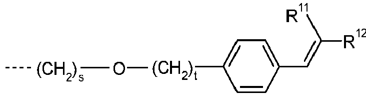 |
| Q14a | Q16a |
| 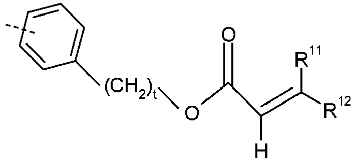 | 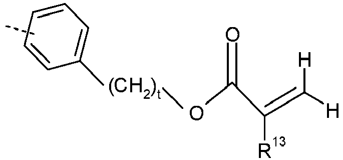 |
| Q19a | Q19b |
| 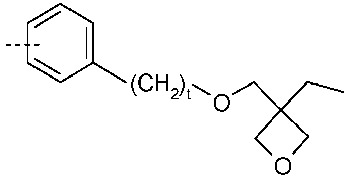 | 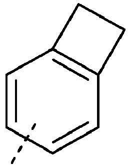 |
| Q21a | Q24a |

Die Reste R¹¹ und R¹² in den Formeln Q7a und Q13a bis Q19a sind bei jedem Auftreten, gleich oder verschieden, H oder eine geradkettige oder verzweigte Alkylgruppe mit 1 bis 6 C-Atomen, vorzugsweise 1 bis 4 C-Atomen. Besonders bevorzugt sind die Reste R¹¹ und R¹² Methyl, Ethyl, n-Propyl, iso-Propyl, n-Butyl, sec-Butyl oder tert-Butyl und ganz besonders bevorzugt Methyl.

Der Rest R¹³ in den Formeln Q7b und Q19b ist bei jedem Auftreten eine geradkettige oder verzweigte Alkylgruppe mit 1 bis 6 C-Atomen, vorzugsweise 1 bis 4 C-Atomen. Besonders bevorzugt ist der Rest R¹³ Methyl, Ethyl, n-Propyl, iso-Propyl, n-Butyl, sec-Butyl oder tert-Butyl und ganz besonders bevorzugt Methyl.

Die verwendeten Indices haben die folgende Bedeutung: s = 0 bis 8 und t = 1 bis 8.

Ganz besonders bevorzugte vernetzbare Gruppen Q sind die folgenden:

| | |
|---|---|
| 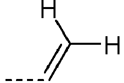 | 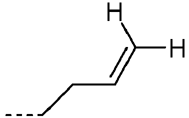 |
| Q1b | Q1c |
| 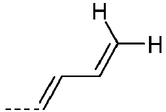 | 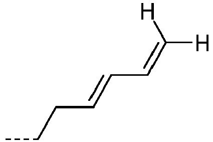 |
| Q2b | Q2c |
| 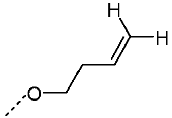 | 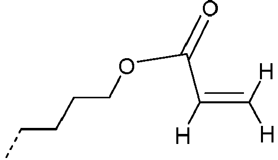 |
| Q4b | Q7c |
| 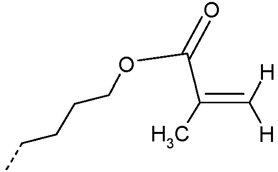 | 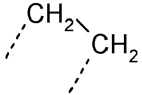 |
| Q7d | Q12b |
| 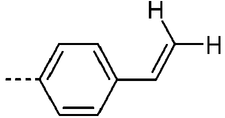 | 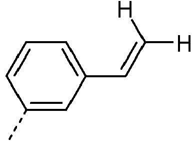 |
| Q13b | Q13c |
| 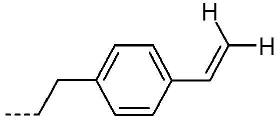 | 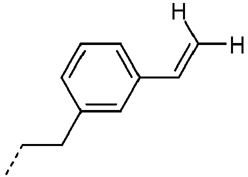 |
| Q13d | Q13e |
| 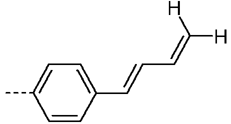 | 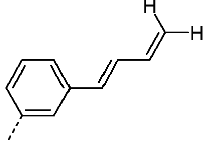 |
| Q14b | Q14c |
| 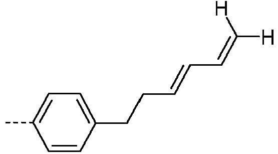 | 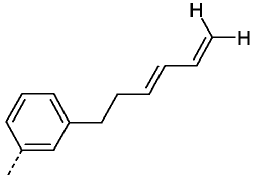 |
| Q14d | Q14e |
| 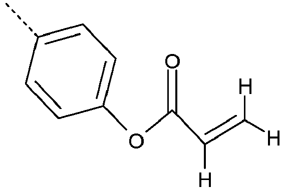 | 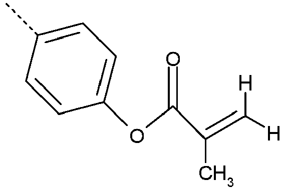 |
| Q19c | Q19d |
| 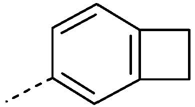 | 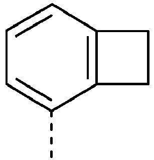 |
| Q24b | Q24c |

In den bevorzugten Gruppen Q1 bis Q24, in den besonders bevorzugten Gruppen Q1a bis Q24a sowie in den ganz besonders bevorzugten Gruppen Q1b bis Q24c stellen die gestrichelten Linien die Bindungen zu den Struktureinheiten dar. Anzumerken ist in diesem Zusammenhang, dass die Gruppen Q12, Q12a, Q12b und Q24 jeweils zwei Bindungen zu zwei benachbarten Ring-Kohlenstoffatomen der Struktureinheit aufweisen. Alle anderen vernetzbaren Gruppen weisen lediglich eine Bindung zu der Struktureinheit auf.

Der Anteil vernetzbarer Struktureinheiten liegt im Polymer im Bereich von 0,01 bis 50 mol%, vorzugsweise im Bereich von 0,1 bis 30 mol%, besonders bevorzugt im Bereich von 0,5 bis 25 mol% und ganz besonders bevorzugt im Bereich von 1 bis 20 mol%, bezogen auf 100 mol% aller copolymerisierten Monomere, die im Polymer als Struktureinheiten enthalten sind.

Die erfindungsgemäßen Polymere enthaltend Struktureinheiten der Formel (la), (II), (III), (IV), (V), (VI), (VII), (VIII), (IX), (X) und/oder (XI) werden in der Regel durch Polymerisation von einer oder mehreren Monomersorten hergestellt, von denen mindestens ein Monomer im Polymer zu Struktureinheiten der Formel (la), (II), (III), (IV), (V), (VI), (VII), (VIII), (IX), (X) und/oder (XI) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation;
(B) YAMAMOTO-Polymerisation;
(C) STILLE-Polymerisation;
(D) HECK-Polymerisation;
(E) NEGISHI-Polymerisation;
(F) SONOGASHIRA-Polymerisation;
(G) HIYAMA-Polymerisation; und
(H) HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Gegenstand der vorliegenden Erfindung ist somit auch ein Verfahren zur Herstellung der erfindungsgemäßen Polymere, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden.

Zur Synthese der erfindungsgemäßen Polymere werden die entsprechenden Monomere der Formel (MI) benötigt, 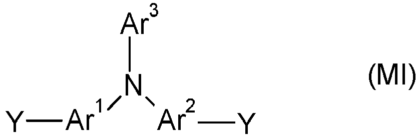 wobei Ar¹, Ar² und Ar³ die in Bezug auf die Struktureinheit der Formel (la) angegebenen Bedeutungen annehmen kann.

Die Monomere der Formel (MI), die in den erfindungsgemäßen Polymeren zu Struktureinheiten der Formel (la) führen, sind Verbindungen, die entsprechend substituiert sind und an zwei Positionen geeignete Funktionalitäten aufweisen, die es erlauben, diese Monomereinheit in das Polymer einzubauen. Diese Monomere der Formel (MI) sind somit ebenfalls Gegenstand der vorliegenden Erfindung. Die Gruppe Y stellt, gleich oder verschieden, eine für eine Polymerisationsreaktion geeignete Abgangsgruppe dar, so dass der Einbau der Monomerbausteine in polymere Verbindungen ermöglicht wird. Vorzugsweise stellt Y eine chemische Funktionalität dar, welche gleich oder verschieden ausgewählt ist aus der Klasse der Halogene, O-Tosylate, O-Triflate, O-Sulfonate, Borsäureester, teilfluorierten Silylgruppen, Diazoniumgruppen und zinnorganischen Verbindungen.

Das Grundgerüst der Monomerverbindungen lässt sich nach Standardmethoden funktionalisieren, beispielsweise durch Friedel-Crafts-Alkylierung oder -Acylierung. Weiterhin lässt sich das Grundgerüst nach Standardmethoden der organischen Chemie halogenieren. Die halogenierten Verbindungen lassen sich in zusätzlichen Funktionalisierungsschritten wahlweise weiter umsetzen. Beispielsweise können die halogenierten Verbindungen entweder direkt oder nach Überführung in ein Boronsäurederivat oder zinnorganisches Derivat als Ausgangsstoffe für die Umsetzung zu Polymeren, Oligomeren oder Dendrimeren eingesetzt werden.

Die genannten Methoden stellen lediglich eine Auswahl aus den dem Fachmann bekannten Reaktionen dar, welche dieser, ohne erfinderisch tätig zu werden, zur Synthese der erfindungsgemäßen Verbindungen einsetzen kann.

Die erfindungsgemäßen Polymere können als Reinsubstanz, aber auch als Mischung zusammen mit weiteren beliebigen polymeren, oligomeren, dendritischen oder niedermolekularen Substanzen verwendet werden. Als niedermolekulare Substanz versteht man in der vorliegenden Erfindung Verbindungen mit einem Molekulargewicht im Bereich von 100 bis 3000 g/mol, vorzugsweise 200 bis 2000 g/mol. Diese weiteren Substanzen können z.B. die elektronischen Eigenschaften verbessern oder selbst emittieren. Als Mischung wird vor- und nachstehend eine Mischung enthaltend mindestens eine polymere Komponente bezeichnet. Auf diese Art können eine oder mehrere Polymerschichten bestehend aus einer Mischung (Blend) aus einem oder mehreren erfindungsgemäßen Polymeren mit einer Struktureinheit der Formel (la), (II), (III), (IV), (V), (VI), (VII), (VIII), (IX) und/oder (X) und optional einem oder mehreren weiteren Polymeren mit einer oder mehreren niedermolekularen Substanzen hergestellt werden.

Ein weiterer Gegenstand der vorliegenden Erfindung ist somit ein Polymer Blend enthaltend ein oder mehrere erfindungsgemäße Polymere, sowie eine oder mehrere weitere polymere, oligomere, dendritische und/oder niedermolekulare Substanzen.

Gegenstand der Erfindung sind weiterhin Lösungen und Formulierungen aus einem oder mehreren erfindungsgemäßen Polymeren oder einem Polymer Blend in einem oder mehreren Lösungsmitteln. Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere enthaltend Struktureinheiten, die eine vernetzbare Gruppe Q aufweisen, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Dabei können sowohl entsprechende Polymere in Reinsubstanz verwendet werden, es können aber auch Formulierungen oder Mischungen dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 beschrieben. Mögliche Bindemittel sind beispielsweise Polystyrol, Polycarbonat, Poly(meth)-acrylate, Polyacrylate, Polyvinylbutyral und ähnliche, optoelektronisch neutrale Polymere.

Geeignete und bevorzugte Lösungsmittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-tetramethylbenzol, 1-Methylnaphtalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzyl ether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösungsmittel.

Ein weiterer Gegenstand der vorliegenden Erfindung ist somit die Verwendung eines Polymers, das Struktureinheiten enthält, die eine vernetzbare Gruppe Q aufweisen, zur Herstellung eines vernetzten Polymers. Die vernetzbare Gruppe, die besonders bevorzugt eine Vinylgruppe oder Alkenylgruppe ist, wird vorzugsweise durch die WITTIG-Reaktion oder eine WITTIG-analoge Reaktion in das Polymer eingebaut. Ist die vernetzbare Gruppe eine Vinylgruppe oder Alkenylgruppe, so kann die Vernetzung durch radikalische oder ionische Polymerisation stattfinden, wobei diese thermisch oder durch Strahlung induziert werden kann. Bevorzugt ist die radikalische Polymerisation, die thermisch induziert wird, vorzugsweise bei Temperaturen von weniger als 250°C, besonders bevorzugt bei Temperaturen von weniger als 230°C.

Wahlweise wird während des Vernetzungsverfahrens ein zusätzliches Styrol-Monomer zugesetzt, um einen höheren Grad der Vernetzung zu erzielen. Vorzugsweise ist der Anteil des zugesetzten Styrol-Monomers im Bereich von 0,01 bis 50 mol%, besonders bevorzugt 0,1 bis 30 mol%, bezogen auf 100 mol% aller copolymerisierten Monomere, die im Polymer als Struktureinheiten enthalten sind.

Gegenstand der vorliegenden Erfindung ist somit auch ein Verfahren zur Herstellung eines vernetzten Polymers, das folgende Schritte umfasst:
(a) Bereitstellen von Polymeren, die Struktureinheiten enthalten, die eine oder mehrere vernetzbare Gruppen Q aufweisen; und
(b) Radikalische oder ionische Vernetzung, vorzugsweise radikalische Vernetzung, die sowohl thermisch als auch durch Strahlung, vorzugsweise thermisch, induziert werden kann.

Die durch das erfindungsgemäße Verfahren hergestellten vernetzten Polymere sind in allen gängigen Lösungsmitteln unlöslich. Auf diese Weise lassen sich definierte Schichtdicken herstellen, die auch durch das Aufbringen nachfolgender Schichten nicht wieder gelöst bzw. angelöst werden.

Die vorliegende Erfindung betrifft somit auch ein vernetztes Polymer, das durch das zuvor genannte Verfahren erhältlich ist. Das vernetzte Polymer wird - wie vorstehend beschrieben - vorzugsweise in Form einer vernetzen Polymerschicht hergestellt. Auf die Oberfläche einer solchen vernetzten Polymerschicht kann aufgrund der Unlöslichkeit des vernetzten Polymers in sämtlichen Lösungsmitteln eine weitere Schicht aus einem Lösungsmittel mit den oben beschriebenen Techniken aufgebracht werden.

Die vorliegende Erfindung umfasst auch sogenannte Hybridvorrichtungen, in der eine oder mehrere Schichten, die aus Lösung prozessiert werden, und Schichten, die durch Aufdampfen von niedermolekularen Substanzen hergestellt werden, vorkommen können.

Die erfindungsgemäßen Polymere können in elektronischen oder optoelektronischen Vorrichtungen bzw. zu deren Herstellung verwendet werden.

Ein weiterer Gegenstand der vorliegenden Erfindung ist somit die Verwendung der erfindungsgemäßen Polymere in elektronischen oder optoelektronischen Vorrichtungen, vorzugsweise in organischen Elektrolumineszenzvorrichtungen (OLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen Elektrolumineszenzvorrichtungen (OLED).

Im Fall der zuvor genannten Hybridvorrichtung spricht man in Verbindung mit organischen Elektrolumineszenzvorrichtungen von kombinierten PLED/SMOLED (Polymeric Light Emitting Diode/Small Molecule Organic Light Emitting Diode) Systemen.

Wie OLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen Polymere ganz besonders als Elektrolumineszenzmaterialien in derart hergestellten OLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung der erfindungsgemäßen Polymere in OLEDs, insbesondere als Elektrolumineszenzmaterial.

Gegenstand der vorliegenden Erfindung sind ferner elektronische oder optoelektronische Bauteile, vorzugsweise organische Elektrolumineszenzvorrichtungen (OLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen und organische Photorezeptoren (OPCs), besonders bevorzugt organische Elektrolumineszenzvorrichtungen, mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht, eine Ladungstransportschicht und/oder eine Ladungsinjektionsschicht sein.

Im vorliegenden Anmeldungstext und auch in den im Weiteren folgenden Beispielen wird hauptsächlich auf die Verwendung der erfindungsgemäßen Polymere in Bezug auf OLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiele:

### Teil A: Synthese der Monomere

Alle Synthesen werden in einer Argon-Atmosphäre und in trockenen Lösungsmitteln durchgeführt, soweit nichts anderes beschrieben wird.

### A1 Herstellung von Vorstufen

### A1.1 Herstellung von 3-Chlor-3,7-dimethyloctan

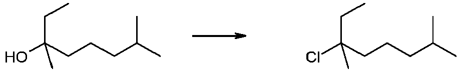

100 ml (522 mmol) 3,7-Dimethyloctanol (CAS 78-69-3) werden vorgelegt, mit 0,2 ml (2 mmol) Pyridin versetzt und auf -5°C abgekühlt. 45,6 ml (628 mmol) Thionylchlorid werden unter Rühren so zugetropft, dass die Temperatur 5°C nicht übersteigt. Entstehendes HCl- und SO₂-Gas wird mit einem Argon-Strom aus der Apparatur getrieben und über einen Waschturm abgeleitet. Nach beendeter Zugabe wird 2 Stunden gerührt, dann wird die Kühlung entfernt und für 12 Stunden nachgerührt. Über eine Vigreux-Kolonne (etwa 10 cm Länge) wird bei Raumtemperatur unter reduziertem Druck zunächst überschüssiges Thionylchlorid abdestilliert. Dann wird das Produkt bei 2 mbar und einer Kopftemperatur von 60 bis 65°C fraktioniert destilliert. Man erhält 88,9 g (96% der Theorie) des Produkts als farbloses Öl.

### A1.2 Herstellung der alkylierten Aromaten Alk1 bis Alk4

Die Herstellung alkylierter Aromaten erfolgt mittels Friedel-Crafts-Reaktion gemäß der im folgenden beispielhaft beschriebenen Verfahren A und B.

### Verfahren A:

### Alkylierung mit t-Butylchlorid zu 4,4'-Di-t-butylbiphenyl (Alk1)

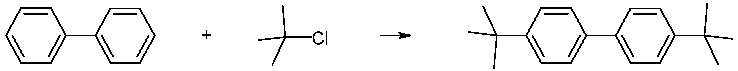

613 g Biphenyl (3,975 mol) werden in 2,5 l Dichlormethan gelöst und mit 24,5 g (0,15 mol) Eisen(III)chlorid versetzt. Bei Raumtemperatur werden unter kräftigem Rühren 1227 ml *t*-Butylchlorid (11,130 mol) innerhalb von 3 Stunden zugetropft. Entstehendes HCl-Gas wird dabei mit einem ArgonStrom aus der Apparatur getrieben und über einen Waschturm abgeleitet. Nach vollständiger Zugabe wird die Mischung für 4 Stunden zum Rückfluß erhitzt. Dann wird die Heizung entfernt und für weitere 12 Stunden nachgerührt. Die Mischung wird über etwa 750 g Kieselgel filtriert, das mit etwa 500 ml Dichlormethan nachgewaschen wird. Die gelbe Lösung wird am Rotationsverdampfer vollständig vom Lösungsmittel befreit, der verbleibende orangefarbene Feststoff wird mit etwa 2 l Ethanol bei 60°C ausgerührt. Die Mischung wird für 1 Stunde auf 0°C abgekühlt, dann wird der Feststoff abgesaugt und zweimal mit je 300 ml kaltem Ethanol gewaschen. Nach Trocknen im Vakuumtrockenschrank verbleiben 827 g (78% der Theorie) als hellgelber kristalliner Feststoff.

### Verfahren B:

### Alkylierung mit 3-Chlor-3,7-dimethyloctan zu Di-(3,7-dimethyloctan-3-yl)-biphenyl (Alk2)

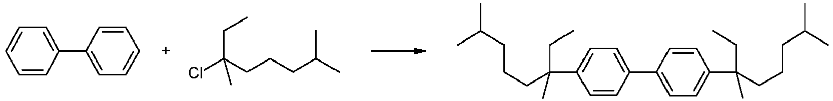

24,7 g (160 mmol) Biphenyl und 26,0 g (160 mmol) Eisen(III)chlorid werden ohne Lösungsmittel vorgelegt, mit einem KPG-Rührer durchmischt. Unter Kühlung mit einem Eisbad werden 85,0 g (480 mmol) 6-Chlor-3,7-dimethyl-octan innerhalb von 30 Minuten zugetropft, wobei das Gemisch zunehmend besser rührbar wird. Entstehendes HCl-Gas wird dabei mit einem ArgonStrom aus der Apparatur getrieben und über einen Waschturm abgeleitet. Nach vollständiger Zugabe wird noch 4 Stunden gerührt und dann mit etwa 100 ml Heptan versetzt. Die Suspension wird über etwa 30 g Kieselgel filtriert, das mit etwa 500 ml Heptan nachgewaschen wird. Die hellgelbe Lösung wird am Rotationsverdampfer vollständig vom Lösungsmittel befreit, es verbleibt ein gelbes Öl. Dieses wird über eine Destillationsbrücke ohne Kühlung bei 10⁻² mbar und einer Kopftemperatur von bis zu 170°C von überschüssigem 3-Chlor-3,7-dimethyloctan und monosubstituiertem Biphenyl befreit. Gegebenenfalls können auch geringe Mengen von nicht umgesetztem Biphenyl in der Brücke kristallisieren. Im Sumpf verbleiben 54,9 g (79% der Theorie als Isomerengemisch) als gelbes Öl.

Eine GC-MS Analyse von Alk2 zeigt drei Verbindungen im Verhältnis von etwa 60:35:5 Flächenprozent der Peaks im GC mit der für das Produkt zu erwartenden Masse. NMR-Spektroskopie und die intermediär anzunehmenden tertiären Carbokationen während der Alkylierung machen die folgenden Substitutionsmuster wahrscheinlich (Stereoisomere werden vernachlässigt).

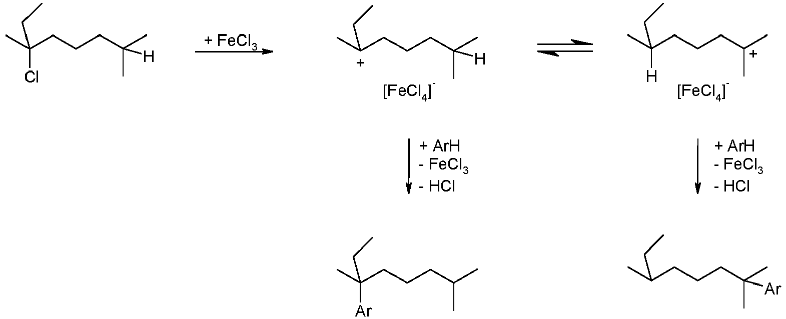

Daher sollen nachfolgend die abgebildeten C₁₀-Alkylsubstituenten stellvertretend für die möglichen Isomere und/oder deren Gemische in beliebiger prozentualer Zusammensetzung stehen.

In analoger Weise kann Fluoren zu Alk3 und Alk4 alkyliert werden:

| Bezeichnung Produkt | Edukt | Produkt | Verfahren Ausbeute |
|---|---|---|---|
| Alk3 | 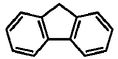 | 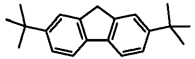 | A 82% |
| Alk4 | 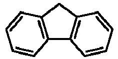 | 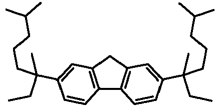 | B 79% |

### A1.3 Herstellung der Bromide Bro1 bis Bro7

### A1.3.1 Bromierung der Verbindungen Alk1 bis Alk4

### Herstellung von 2-Brom-4,4`-di-t-butylbiphenyl (Bro1)

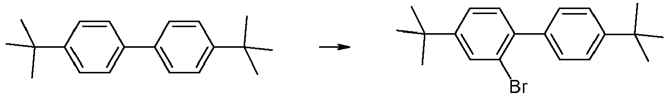

54,9 g (126 mmol) 4,4'-Di-*t*-butylbiphenyl werden in 120 ml gelöst. 12,9 ml (253 mmol) Brom in 40 ml Dichlormethan werden bei Raumtemperatur unter Rühren innerhalb von 15 Minuten zugetropft, wobei die Mischung zu sieden beginnt. Es wird noch 3 Stunden zum Rückfluß erhitzt. Dann wird die Mischung auf 0°C abgekühlt und unter kräftigem Rühren mit 50 ml gesättigter wäßriger Natriumthiosulfat-Lösung versetzt und 15 Minuten nachgerührt. Die Phasen werden getrennt. Die organische Phase wird zweimal mit gesättigter wäßriger Natriumthiosulfat-Lösung und zweimal mit gesättigter wäßriger Natriumhydrogencarbonat-Lösung gewaschen, über Natriumsulfat getrocknet und am Rotationsverdampfer vom Lösungsmittel befreit. Der Rückstand wird in 50 ml Heptan aufgenommen und über etwa 50 g Kieselgel filtriert, das mit 100 ml Heptan nachgewaschen wird. Das Lösungsmittel wird am Rotationsverdampfer entfernt. Der verbleibende Rückstand wird in einer Kurzwegdestillation bei 10⁻³ mbar und einer stufenweise erhöhten Manteltemperatur von bis zu 180 °C gereinigt. Es verbleiben 60,6 g (81% der Theorie) als gelblicher Feststoff.

In analoger Weise können die Bromide Bro2 und Bro3 dargestellt werden:

| Bez. Produkt | Edukt | Produkt | Ausbeute |
|---|---|---|---|
| Bro2 | 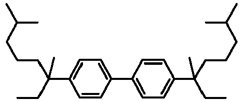 | 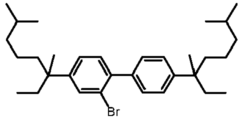 | 70% |
| Bro3 | 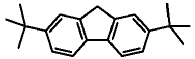 | 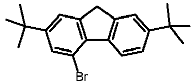 | 84% |

### In analoger Weise kann bei Verwendung von zwei Äquivalenten Brom auch 2,2`-Dibrom-4,4`-di-t-butylbiphenyl (Bro4) mit einer Ausbeute von 68% dargestellt werden:

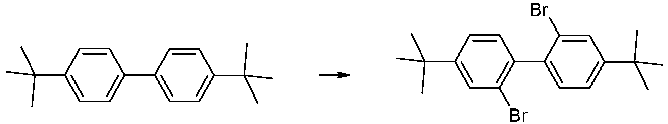

### A1.3.2 Herstellung von Bro5

4-Brom-2,7-di-*t*-butylfluoren (Bro3) kann gemäß Bull. Chem. Soc. Jpn. 1986, 59, 97-103 zu 4-Bromfluoren (Bro5) dealkyliert werden:

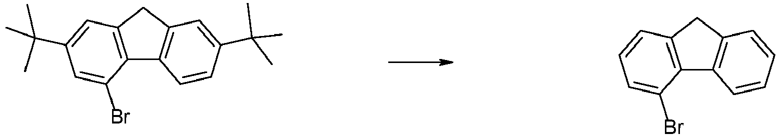

### A1.3.3 Herstellung von Bro6

4-Brom-2,7-di-*t*-butylfluoren (Bro3) kann analog zu Organometallics 2013, 32, 460-467 mit 1-lodoctan (CAS 629-27-6) zu 4-Brom-2,7-di-*t*-butyl-9,9-di-*n*-octylfluoren (Bro6) alkyliert werden.

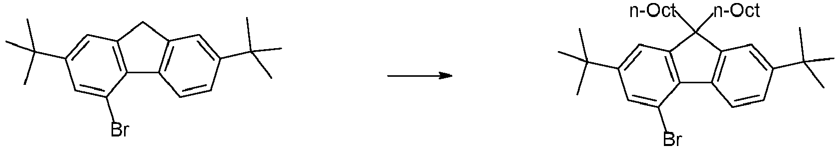

In analoger Weise kann Bro7 hergestellt werden

| Bez. Produkt | Edukt | Produkt | Ausbeute |
|---|---|---|---|
| Bro7 | 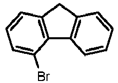 | 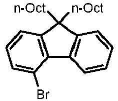 | 87% |

### A1.4 Herstellung der Fluorenone Flu1 bis Flu3

4-Brom-2,7-di-*t*-butylfluoren kann gemäß Bull. Chem. Soc. Jpn. 1988, 61, 995-996 mit Kaliumpermanganat zu 4-Brom-2,7-di-*t*-butylfluorenon (Flu1) oxidiert werden:

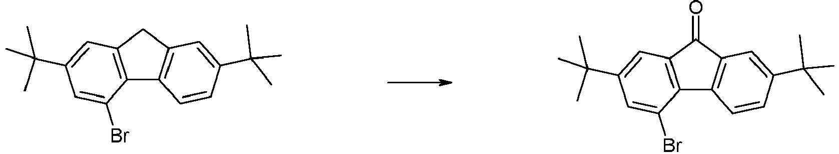

In analoger Weise können die Verbindungen Flu2 und Flu3 hergestellt werden:

| Bez. Produkt | Edukt | Produkt | Ausbeute |
|---|---|---|---|
| Flu2 | 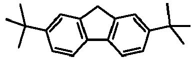 | 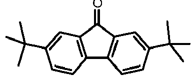 | 84% |
| Flu3 | 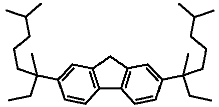 | 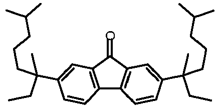 | 71% |

### A1.5 Herstellung der Spirobifluorene Spi1 bis Spi7

4-Brom-9,9'-spirobifluoren (Spi1) kann analog zu Organic Letters 2009, 11, 2607-2610 nach folgendem Schema mit einer Ausbeute von 77% über beide Stufen hergestellt werden.

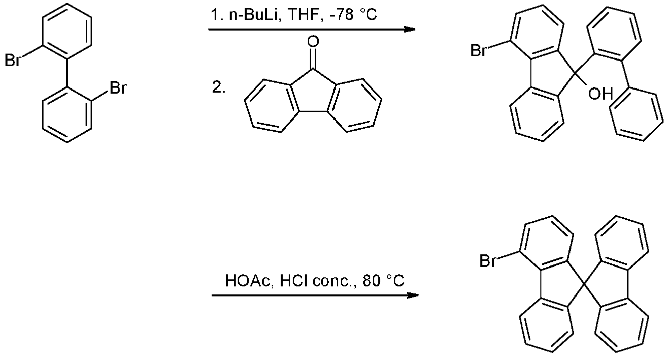

In analoger Weise können 2,7-dialkylsubstituierte und 2,2',7,7'-tetraalkylierte 4-Brom-9,9`-spirobifluorene hergestellt werden, wie beispielhaft für die Verbindungen Spi2 bis Spi4 gezeigt:

| Bez. Produkt | Edukt Bromid | Edukt Fluorenon | Produkt | Ausbeute |
|---|---|---|---|---|
| Spi2 | 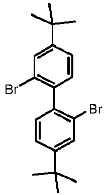 | 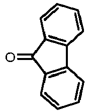 | 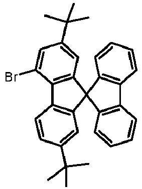 | 82% |
| Spi3 | 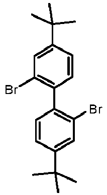 | 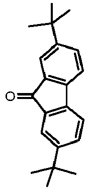 | 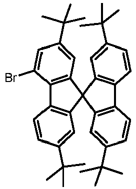 | 77% |
| Spi4 | 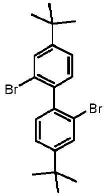 | 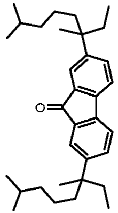 | 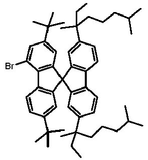 | 60% |
| Spi5 | 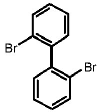 CAS 13029-09-9 | 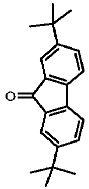 | 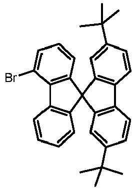 | 72% |

In einem analogen Verfahren können durch Reaktion von 4,4'-dialkylsubstituiertem 2-Brombiphenyl und 4-Bromfluorenon 2',7'-dialkylierte 4-Brom-9,9-spirobifluorene hergestellt werden, wie beispielhaft für die Verbindungen Spi6 und Spi7 gezeigt:

| Bez. Produkt | Edukt Bromid | Edukt Fluorenon | Produkt | Ausbeute |
|---|---|---|---|---|
| Spi6 | 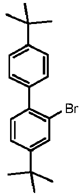 | 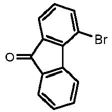 CAS 4269-17-4 | 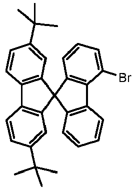 | 85% |
| Spi7 | 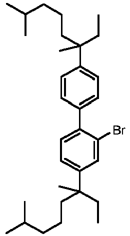 | 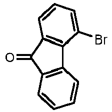 | 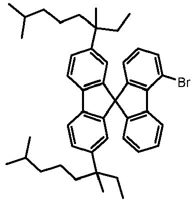 | 68% |

### A1.6 Herstellung der Triarylamine Mo6.A, Mo12.A bis Mo16.A, Mo19.A bis Mo22.A und Mo26.A

### A1.6.1 Herstellung von Mo6.A

2,8-Dibromo-6,6,12,12-tetraoctyl-6,12-dihydro-indeno[1,2-b]fluoren kann gemäß Macromolecules 2000, 33, 2016-2020 hergestellt werden.

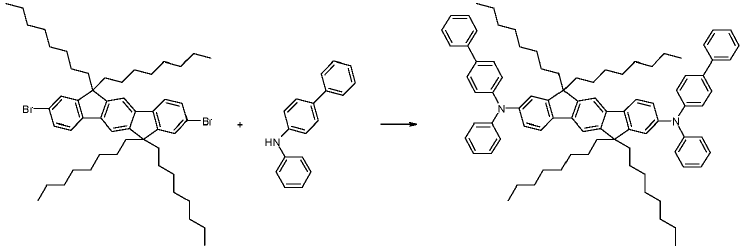

21,7 g (25 mmol) 2,8-Dibromo-6,6,12,12-tetraoctyl-6,12-dihydro-indeno-[1,2-b]fluoren werden in 0,2 l getrocknetem Toluol gelöst, 13,0 g (52 mmol) Biphenyl-4-yl-phenyl-amine (CAS 32228-99-2), 26,3 g (80 mmol) Cäsiumcarbonat und 0,23 g (1 mmol) Palladium(II)acetat werden als Feststoff sukzessive zugegeben und die Lösung mit Stickstoff gesättigt. 2,0 ml (2 mmol) Tri-t-butylphosphin-Lösung (1 M in Toluol) werden zugegeben und die Reaktionsmischung unter Rückfluß 24 Stunden gerührt.

Der Feststoff wird abfiltriert und mit Toluol gewaschen. Die Filtrate werden eingeengt, mit Ethanol heiß verrührt, abgesaugt und zusammen mit dem ausgefallenen Feststoff im Vakuumtrockenschrank getrocknet. Es verbleiben 26,8 g (90% der Theorie) als gelber Feststoff.

### A1.6.2 Herstellung von Mo12.A bis Mo16.A, Mo19.A bis Mo22.A

### Verfahren A:

### Herstellung von Biphenyl-2-yl-diphenylamin (Mo13.A)

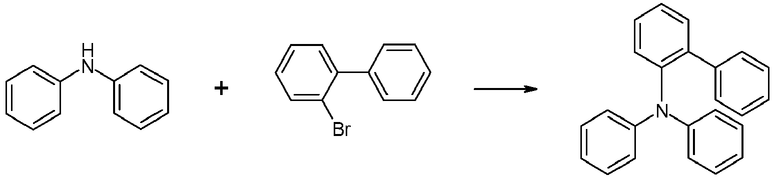

120,0 g (515 mmol) 2-Brombiphenyl, 87,1 g (515 mmol) Diphenylamin und 74,2 g (772 mmol) Natrium-*t*-butylat werden in 2 l Toluol suspendiert. Das Gemisch wird mit Argon gesättigt, mit 10 ml (10 mmol) Tri-*t*-butylphosphin (1M in Toluol) und 1,1 g (5 mmol) Palladium(II)acetat versetzt und für 6 Stunden zum Rückfluß erhitzt. Nach Abkühlen auf Raumtemperatur werden feste Bestandteile abfiltriert, die organische Phase wird dreimal mit je 500 ml Wasser gewaschen, über Natriumsulfat getrocknet und am Rotationsverdampfer vom Lösungsmittel befreit. Der verbleibende Feststoff wird zweimal mit je 300 ml Heptan für 30 Minuten gerührt, abfiltriert und im Vakuumtrockenschrank getrocknet. Es verbleiben 126,0 g (76% der Theorie) als beigefarbener Feststoff.

### Verfahren B:

Für Verbindungen, die im letzten Schritt nicht als Feststoff oder nach Umkristallisation nicht in ausreichender Reinheit anfallen, wird eine säulenchromatographische Reinigung über Kieselgel (etwa 15 g pro Gramm Substanz) mit Heptan bzw. Toluol als Laufmittel durchgeführt.

Analog zu den beschriebenen Verfahren können die Verbindungen Mo12.A, Mo14.A bis Mo16.A und Mo19.A bis Mo22.A hergestellt werden:

| Bez. Produkt | Edukt | Produkt | Verf. (Laufmittel) Ausbeute |
|---|---|---|---|
| Mo12.A | 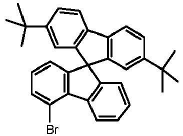 | 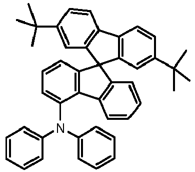 | A |
| | | | 81% |
| Mo14.A | 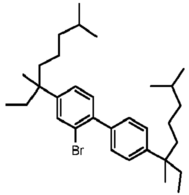 | 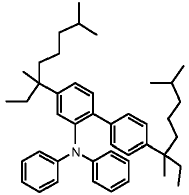 | B (Toluol) |
| | | | 58% |
| Mo15.A | 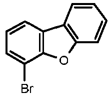 CAS 89827-45-2 | 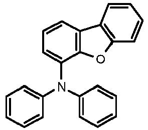 | A |
| | | | 84% |
| Mo16.A | 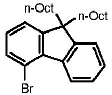 | 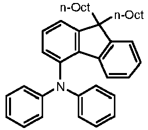 | B (Heptan) |
| | | | 64% |
| Mo19.A | 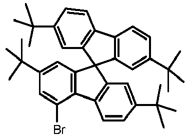 | 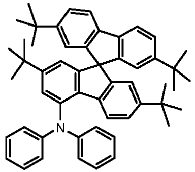 | A |
| | | | 73% |
| Mo20.A | 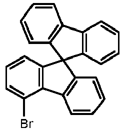 | 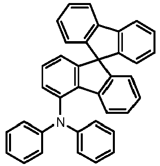 | A |
| | | | 80% |
| Mo21.A | 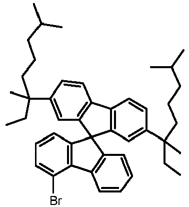 | 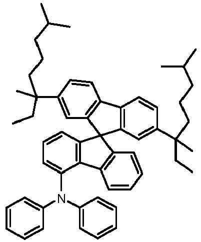 | B (Toluol) |
| | | | 68% |
| Mo22.A | 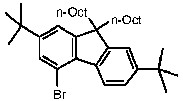 | 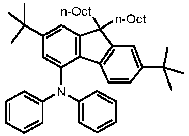 | B (Heptan) |
| | | | 69% |

### A1.6.3 Herstellung von [9,9-bis-(4-formylphenyl)fluoren-4-yl]-diphenylamin (Mo26.A)

### Stufe 1

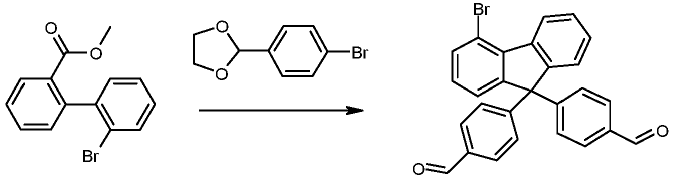

In einem ersten Kolben werden 66,1 g (0.29 mol) 2-(4-Bromphenyl)-[1,3]-dioxolan (CAS 10602-01-4) in 200 ml getrocknetem THF gelöst. Die Mischung wird auf -78°C abgekühlt und 115 ml einer 2,5 M Lösung von *n*-BuLi in Hexan (0,29 mol) werden langsam zugetropft. Die Mischung wird eine Stunde bei -78°C gerührt und dann innerhalb von 2 Stunden auf 20°C erwärmt.

In einem zweiten Kolben werden 40,0 g (137 mmol) 2'-Brombiphenyl-2-carboxylsäuremethylester (CAS 1000071-27-1) in 150 ml getrocknetem THF gelöst. Diese Mischung wird auf -78°C gekühlt und die Mischung des ersten Kolbens wird vorsichtig unter Argonströmung zugetropft. Die Reaktionsmischung wird eine Stunde bei -78°C gerührt, dann langsam auf 20°C erwärmt und 16 Stunden bei dieser Temperatur gerührt.

Die Reaktionsmischung wird auf 0°C gekühlt und mit Eisessig angesäuert. Die Mischung wird dann 2 Stunden unter Rückfluß gekocht. Anschließend werden 50 ml einer 0,1 M wäßrigen HCl-Lösung zugegeben. Die Reaktionsmischung wird weitere 20 Stunden unter Rückfluß gerührt. 200 ml Wasser werden zugegeben, die Phasen werden getrennt und die organische Phase wird dreimal mit 200 ml Wasser gewaschen, getrocknet, über Aluminiumoxid (basisch, Aktivitätsstufe 1) filtriert und eingeengt. Der Rückstand wird mit Heptan heiß verrührt, abgesaugt und im Vakuumtrockenschrank getrocknet. Es verbleiben 27,4 g (44% der Theorie) als weißer Feststoff.

### Stufe 2:

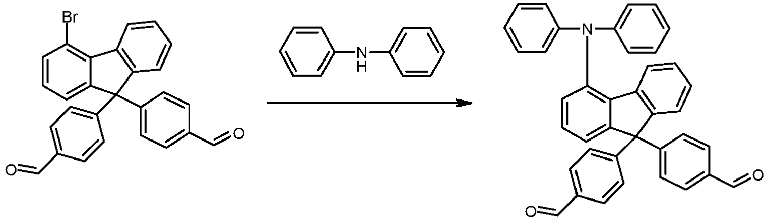

26,5 g (58.5 mmol) 4-Brom-9,9-bis-(4-formylphenyl)fluoren werden in 0,2 l getrocknetem Toluol gelöst, 9,9 g (58,5 mmol) Diphenylamin, 38,1 g (0,12 mol) Cäsiumcarbonat und 0,26 g (1,1 mmol) Palladium(II)acetat werden sukzessive zugegeben und die Mischung mit Stickstoff gesättigt. 2,3 ml (2,3 mmol) Tri-t-butylphosphin (1 M in Toluol) werden zugegeben und die Reaktionsmischung unter Rückfluß 24 Stunden gerührt.

Der Feststoff wird abfiltriert und mit Toluol gewaschen. Die Filtrate werden zusammen über Aluminiumoxid (basisch, Aktivitätsstufe 1) und Kieselgel filtriert, eingeengt, mit Heptan heiß verrührt, abgesaugt und im Vakuumtrockenschrank getrocknet. Es verbleiben 20,6 g (65% der Theorie) als weißer Feststoff.

### A2. Herstellung der Monomere

### A2.1 Herstellung von 3,3'-Bis(pinacolatoboranyl)biphenyl (Mo10)

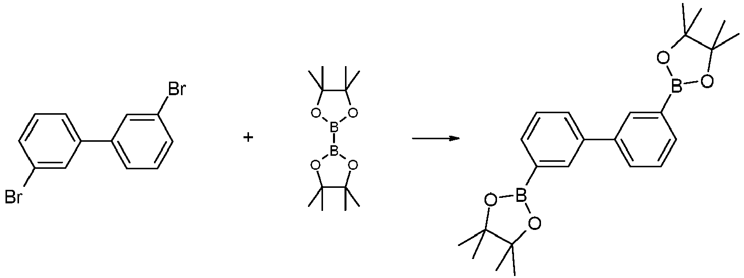

100,0 g (321 mmol) 3,3'-dibromo-1,1`-biphenyl (CAS 16400-51-4), 244,2 g Bis(pinacolato)diboran (963 mmol), 125,8 g (1.3 mol) Kaliumacetat und 5,24 g (6 mmol) 1,1-Bis(diphenylphosphino)ferrocen-dichloropalladium(II) werden in 1 l Tetrahydrofuran unter kräftigem Rühren für 2 Tage zum Rückfluß erhitzt. Die Reaktionsmischung wird bei Raumtemperatur über Celite filtriert. Das Lösungsmittel wird im Vakuum entfernt, der verbleibende Feststoff in Acetonitril umkristallisiert. Der dabei entstehende Feststoff wird abfiltriert, im Vakuum getrocknet und anschließend bei 140 °C und einem Druck von 10⁻⁵ mbar sublimiert. Man erhält 55,7 g (43% der Theorie) des Produkts als farbloses Pulver mit einer Reinheit von 99,7% nach HPLC.

### A2.2 Erfindungsgemäße Triarylamine mit 4-Bromphenyl-Resten

### A2.2.1 Herstellung von Mo6

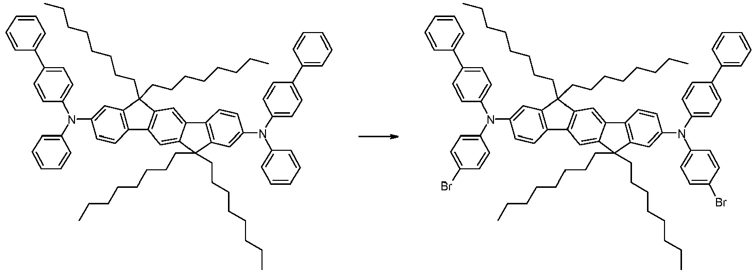

26,0 g (21 mmol) *N*,*N*'-Bis(biphenyl-4-yl)-6,6,12,12-tetraoctyl-*N*,*N*'-diphenyl-6H,12H-indeno[1,2-b]fluoren-2,8-diamin werden in 600 ml getrocknetem THF gelöst und auf 0°C abgekühlt. 7,8 g (43 mmol) *N*-Bromsuccinimid werden als Feststoff portionsweise zugegeben und die Lösung bei Raumtemperatur für 14 Stunden gerührt.

Die Reaktionsmischung wird eingeengt. Der Rückstand wird in Ethanol heiß verrührt. Der Feststoff wird abfiltriert, dreimal aus Ethylacetat umkristallisiert (etwa 1000 ml) und anschließend im Vakuumtrockenschrank getrocknet. Man erhält 23,0 g (78% der Theorie) des Produkts als gelbes Pulver mit einer Reinheit von 97,7% nach HPLC.

### A2.2.2 Herstellung von Mo12 bis Mo15, Mo16.Br, Mo19.Br bis Mo22.Br und Mo26.Br

### Verfahren A:

### Herstellung von Biphenyl-2-yl-bis-(4-bromphenyl)amin (Mo13)

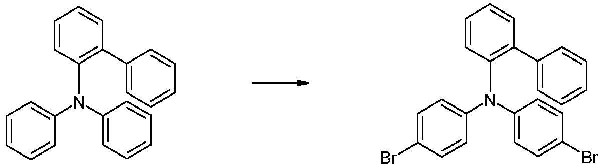

93,2 g (290 mmol) Biphenyl-2-yl-diphenylamin (Mo13.A) werden in 1800 ml THF vorgelegt und auf 0°C gekühlt. Dann werden unter kräftigem Rühren portionsweise 103,2 g (580 mmol) *N*-Bromsuccinimid als Feststoff so zugegeben, daß die Temperatur der Mischung 5°C nicht übersteigt. Die Kühlung wird entfernt und die Mischung weitere 12 Stunden gerührt. Das Lösungsmittel wird am Rotationsverdampfer vollständig entfernt. Der Rückstand wird in etwa 500 ml Toluol gelöst, über Aluminiumoxid (basisch, Aktivitätsstufe 1) filtriert und erneut am Rotationsverdampfer bis zur Trockne eingeengt. Der verbleibende Feststoff wird dreimal aus etwa 850 ml Heptan umkristallisiert. Gegebenenfalls noch enthaltene Reste von Succinimid können durch mehrfaches warmes Ausrühren des Feststoffs mit Ethanol entfernt werden. Nach Absaugen und Trocknen im Vakuumtrockenschrank wird dieser zweimal bei 10⁻⁵ mbar und 260°C fraktioniert sublimiert. Es verbleiben 101,7 g (71% der Theorie) als farbloser glasartiger Feststoff mit einer Reinheit von 99,8% nach HPLC.

### Verfahren B:

Für Verbindungen, die nach Filtration über Aluminiumoxid und Entfernen des Lösungsmittels nicht als Feststoff oder nach Umkristallisation nicht in ausreichender Reinheit anfallen, wird eine säulenchromatographische Reinigung über Kieselgel (etwa 10 g pro Gramm Substanz) mit Toluol als Laufmittel durchgeführt. Dann wird das Lösungsmittel am Rotationsverdampfer so weit wie möglich entfernt und abschließend bei 10⁻⁵ mbar und 150°C getempert, um Reste von Lösungsmitteln und flüchtige Verunreinigungen zu entfernen.

Analog zu den beschriebenen Verfahren können die folgenden Verbindungen hergestellt werden:

| Beispiel | Edukt | Produkt | Verfahren Ausbeute (Reinheit HPLC) |
|---|---|---|---|
| Mo12 | Mo12.A | 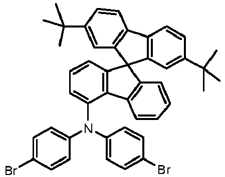 | A |
| | | | 62% |
| | | | (99.9%) |
| Mo14 | Mo14.A | 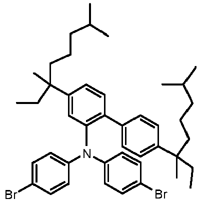 | B |
| | | | 44% |
| | | | (99.7%) |
| Mo15 | Mo15.A | 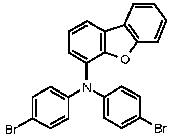 | B |
| | | | 31% |
| | | | (99.9%) |
| Mo16.Br | Mo16.A | 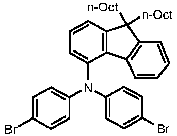 | B |
| | | | 57% |
| | | | (99.7) |
| Mo19.Br | Mo19.A | 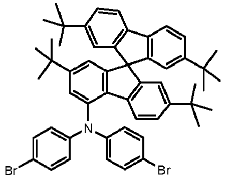 | A |
| | | | 61% |
| | | | (99.8%) |
| Mo20.Br | Mo20.A | 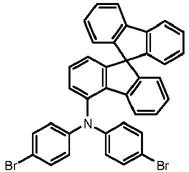 | A |
| | | | 61% |
| | | | (99.9%) |
| Mo21.Br | Mo21.A | 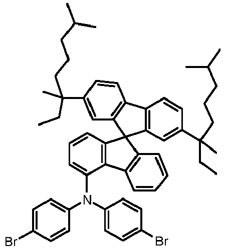 | A |
| | | | 35% |
| | | | (99.5%) |
| Mo22.Br | Mo22.A | 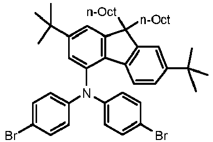 | B |
| | | | 52% |
| | | | (99.8%) |
| Mo26.Br | Mo26.A | 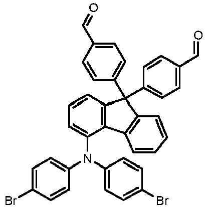 | A |
| | | | 58% |
| | | | (99.7%) |

### A2.3 Erfindungsgemäße Triarylamine mit 3-Bromphenyl-Resten

### Herstellung von 2',7'-Bis-(3,7-dimethyloctan-3-yl)-9,9'-spirobifluoren-4-yl-bis-(3-bromphenyl)amin (Mo24)

### Stufe 1:

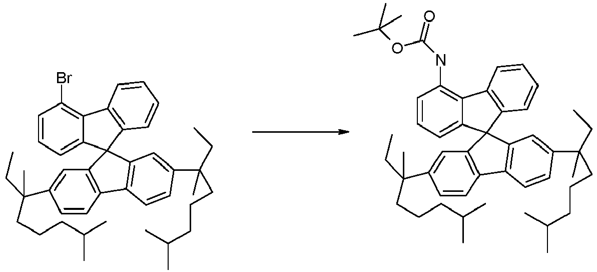

180,0 g (266 mmol) 4-Brom-2',7'-bis-(3,7-dimethyloctan-3-yl)-9,9'-spirobi-fluoren (Spi7) werden in 2 l getrocknetem Dioxan gelöst, 56,2 g (480 mmol) Carbamidsäure-t-butylester (CAS 4248-19-5), 182,5 g (560 mmol) Cäsiumcarbonat und 12,3 g (21,3 mmol) 4,5-Bis(diphenylphosphino)-9,9-dimethyl-xanthen (Xantphos) werden als Feststoffe sukzessive zugegeben, dann wird die Lösung mit Stickstoff gesättigt. 3,6 g (16 mmol) Palladium(II)acetat werden zugegeben und die Reaktionsmischung 2 Tage unter Rückfluß gerührt. Das Lösungsmittel wird am Rotationsverdampfer so weit wie möglich entfernt und der dunkle Rückstand mit Heptan heiß extrahiert. Das Lösungsmittel wird am Rotationsverdampfer vollständig entfernt und der verbleibende Feststoff in einem Toluol-Heptan Gemisch (1:1) umkristallisiert. Der Feststoff wird abgesaugt und im Vakuumtrockenschrank getrocknet. Es verbleiben 119,5 g (63% der Theorie) als hellgelber Feststoff.

### Stufe 2:

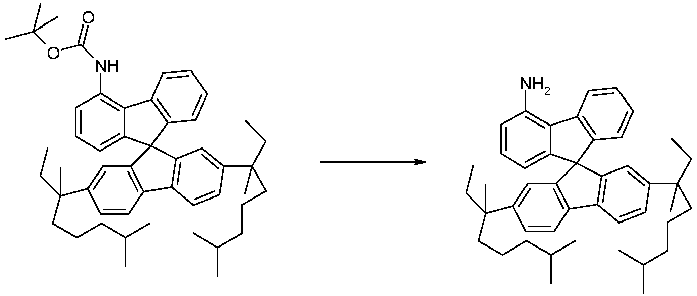

119,0 g (167.2 mmol) *N*-[2',7'-Bis-(3,7-dimethyloctan-3-yl)-9,9'-spirobi-fluoren-4-yl]carbamidsäure-*t*-butylester werden in 500 ml getrocknetem Dichlormethan gelöst, 51,5 ml (670 mmol) Trifluoressigsäure werden vorsichtig zugetropft. Die Reaktionsmischung wird 2 Stunden bei Raumtemperatur gerührt. Die Reaktionsmischung wird eingeengt und der Rückstand in 300 ml Toluol gelöst. Die organische Phase wird zweimal mit je 300 ml NaOH (1M Lösung) und dann mit 400 ml Wasser gewaschen. Die organische Phase wird über Natriumsulfat getrocknet und am Rotationsverdampfer vom Lösungsmittel befreit. Es verbleiben 96,2 g (94% der Theorie) als weißer Feststoff.

### Stufe 3:

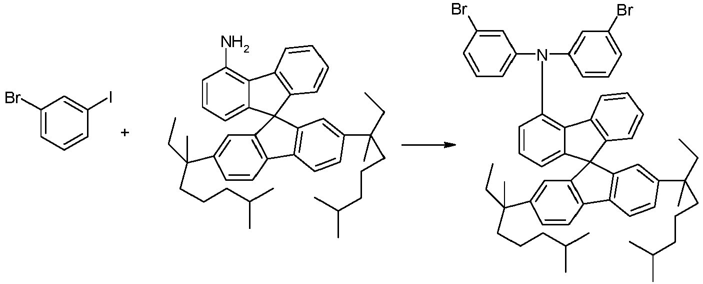

97,8 g (346 mmol) 1-Brom-3-iodbenzol, 96,1 g (157 mmol) 4-Amino-2',7'-bis-(3,7-dimethyloctan-3-yl)-9,9'-spirobifluoren, 2,4 g (12.6 mmol) Kupfer(I)iodid, 70,4 g (1,26 mol) Kaliumhydroxid und 2,27 g (12,6 mmol) 1,10-Phenanthrolin werden in 750 ml *o*-Xylol suspendiert. Die Reaktionsmischung wird mit Argon gesättigt und über Nacht unter Rückfluß gerührt. Das Gemisch wird auf Raumtemperatur abgekühlt und anschließend mit Toluol über Kieselgel und Aluminiumoxid filtriert und einrotiert. Der hellbraune Feststoff wird abgesaugt. Der Feststoff wird dann säulenchromatographisch gereinigt (Heptan). Das Produkt wird in einem Heptan-Toluol-Gemisch (1:1) umkristallisiert. Man erhält 76,8 g (53% der Theorie) des Produkts als farbloses Pulver mit einer Reinheit von 99,7% nach HPLC.

In analoger Weise kann Mo23 hergestellt werden:

| Beispiel | Edukt | Produkt | Ausbeute (HPLC Reinheit) |
|---|---|---|---|
| Mo23 | 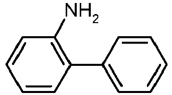 CAS 90-41-5 | 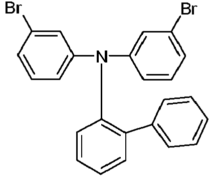 | 64% |
| | | | (99.9%) |

### A2.4 Erfindungsgemäße Triarylamine mit Pinacolatoboronsäureester-Resten

### A2.4.1 Herstellung des Monomers Mo11

### Stufe 1:

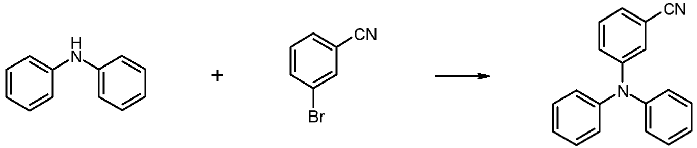

50,0 g (295 mmol) Diphenylamin werden mit 64,5 g (355 mmol) 3-Brombenzonitril, 20 ml (20 mmol) Tri-*t*-butylphosphin-Lösung (1 M in Toluol) 2,65 g (11 mmol) Palladium(II)acetat und 85,2 g (886 mmol) Natrium-*t*-butylat in 1000 ml Toluol vorgelegt und unter Rühren für 15 Stunden zum Rückfluß erhitzt. Nach Abkühlen wird die organische Phase dreimal mit jeweils 1000 ml Wasser gewaschen, über Natriumsulfat getrocknet und anschließend im Vakuum bis zur Trockne eingeengt. Der verbleibende Feststoff wird mit etwa 400 ml Heptan in einem kontinuierlichen Heißextraktor über ein Bett aus Aluminiumoxid (basisch, Aktivitätsstufe 1) extrahiert. Nach Abkühlen wird der ausgefallene Feststoff abfiltriert, zweimal mit etwa 200 ml Heptan gewaschen und unter Vakuum getrocknet. Es verbleiben 53,0 g (66% der Theorie) als schwach gefärbter Feststoff.

### Stufe 2:

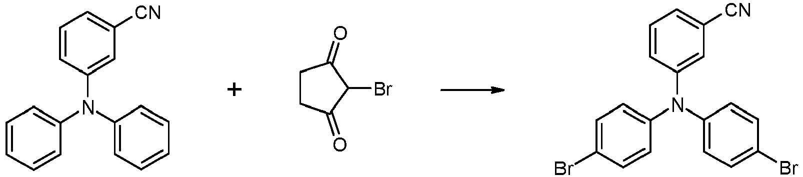

53,0 g (196 mmol) 3-Diphenylaminobenzonitril werden in 500 ml trockenem Tetrahydrofuran gelöst und auf 0°C abgekühlt. Unter Eiskühlung und kräftigem Rühren werden 69,8 g (392 mmol) *N*-Bromsuccinimid als Feststoff portionsweise so zugegeben, dass die Temperatur 5°C nicht übersteigt. Die Kühlung wird entfernt und die Mischung 12 Stunden gerührt. Das Lösungsmittel wird im Vakuum entfernt und der verbleibende Feststoff in möglichst wenig Essigester gelöst. Die Lösung wird dreimal mit etwa 500 ml wäßriger Natriumhydroxid-Lösung (5%) und zweimal mit Wasser gewaschen. Die organische Phase wird bis zur Trockne eingeengt. Es verbleiben 70,8 g (84% der Theorie) als farbloser Feststoff.

### Stufe 3:

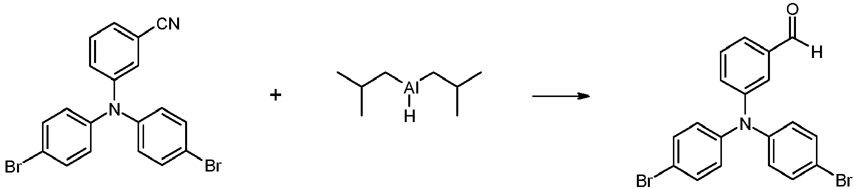

70,8 g (165 mmol) 3-[Bis-(4-bromophenyl)]-benzonitril werden in 700 ml trockenem Dichlormethan gelöst und auf -78°C gekühlt. 174 ml (174 mmol) einer 1 M Lösung von Di-iso-butylaluminiumhydrid in Toluol werden so zugetropft, dass die Temperatur -50°C nicht übersteigt. Man entfernt die Kühlung, läßt das Gemisch auf 10°C aufwärmen und kühlt erneut auf -10°C ab. Nach Zugabe von 175 ml Tetrahydrofuran wird zügig mit einer Mischung aus 43 g konzentrierter Schwefelsäure und 175 ml Wasser versetzt und für 12 Stunden ohne weitere Kühlung gerührt. Das Gemisch wird mit wäßriger Natronlauge neutral gestellt. Die organische Phase wird abgetrennt, zweimal mit etwa 350 ml Wasser und einmal mit 350 ml gesättigter Natriumchlorid-Lösung gewaschen und über Magnesiumsulfat getrocknet. Das Lösungsmittel wird am Rotationsverdampfer entfernt. Dabei verbleibt ein gelbes Öl, das innerhalb von 24 Stunden kristallisiert. Der Feststoff wird mit etwa 300 ml Heptan in einem kontinuierlichen Heißextraktor über ein Bett von Aluminiumoxid (basisch, Aktivitätsstufe 1) extrahiert und nach Abkühlen abfiltriert. Es wird dreimal aus Isopropanol umkristallisiert. Nach Trocknen im Vakuum verbleiben 13,0 g (18% der Theorie) als gelber Feststoff.

### Stufe 4:

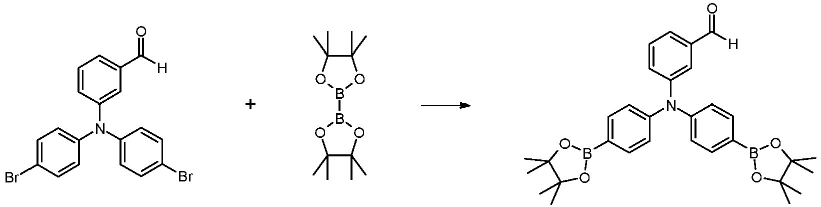

13,0 g (30 mmol) 3-[Bis-(4-bromophenyl)amino]benzaldehyd, 33,7 g (137 mmol) Bis(pinacolato)diboran, 14,8 g (151 mmol) Kaliumacetat, 0,27 g (1.2 mmol) Palladium(II)acetat und 0,69 g (1,2 mmol) Bis(diphenylphos-phino)ferrocen werden in 500 ml Dioxan unter kräftigem Rühren für 14 Stunden zum Rückfluß erhitzt. Das Lösungsmittel wird im Vakuum entfernt, der verbleibende Feststoff in möglichst wenig Essigester aufgenommen und mit einer Mischung von Essigester und Heptan (1:1) über Kieselgel filtriert. Das Lösungsmittel wird im Vakuum entfernt und das verbleibende Öl mit etwa 100 ml Heptan für 2 Stunden gerührt. Der dabei entstehende Feststoff wird abfiltriert, im Vakuum getrocknet und anschließend bei 200°C und einem Druck von 10⁻⁵ mbar fraktioniert sublimiert. Man erhält 3,5 g (22% der Theorie) des Produkts als farbloses Pulver mit einer Reinheit von 99,8% nach HPLC.

### A2.4.2 Herstellung der Monomere Mo16 bis Mo22 sowie Mo25 und Mo26

### Verfahren A:

### Herstellung von Biphenyl-2-yl-bis-(4-pinacolatoboranyl-phenyl)amin (Mo18)

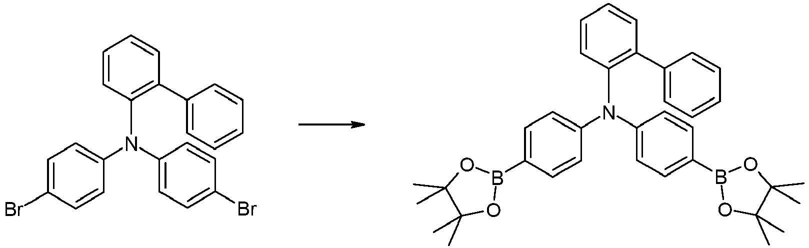

124,6 g (260 mmol) Biphenyl-2-yl-bis-(4-bromphenyl)amin (Mo13), 140 g (551 mmol) Bis(pinacolato)diboran und 128,8 g (1313 mmol) Kaliumacetat werden in 2,4 l Dioxan vorgelegt. Das Gemisch wird mit Argon gesättigt, mit 6,00 g (11 mmol) 1,1'-Bis(diphenylphosphino)ferrocen und 2,47 g (11 mmol) Palladium(II)acetat versetzt und für 14 Stunden zum Rückfluß erhitzt. Nach Abkühlen auf Raumtemperatur wird über etwa 150 g Celite filtriert und das Lösungsmittel am Rotationsverdampfer so weit wie möglich entfernt. Das verbleibende dunkelbraune Öl wird mit etwa 1000 ml Heptan aufgenommen und für 3 Stunden kräftig gerührt, wobei ein brauner Feststoff ausfällt. Nach Absaugen wird der Feststoff aus zwei ineinandergesteckten Extraktionshülsen in einem kontinuierlichen Heißextraktor ohne Adsorptionsmittel mit etwa 1000 ml Heptan etwa 16 Stunden extrahiert. Nach Abkühlen auf Raumtemperatur wird der Feststoff abgesaugt und die Mutterlauge am Rotationsverdampfer bis zur Trockne eingeengt. Beide Feststoffe werden vereinigt und erneut wie beschrieben heißextrahiert; die verwendeten Extraktionshülsen sind nach der zweiten Extraktion nur noch schwach gefärbt. Die Mutterlauge wird erneut zur Trockne eingeengt und mit dem ausgefallenen Feststoffe vereinigt. Man nimmt in etwa 250 ml Heptan auf, erhitzt die Suspension zum Rückfluß und tropft bis zur vollständigen Lösung Toluol zu (etwa 140 ml). Nach Abkühlen auf Raumtemperatur wird der gebildete Feststoff abgesaugt und erneut wie beschrieben umkristallisiert. Nach Absaugen des Feststoffs und Trocknen im Vakuumtrockenschrank wird dieser zweimal bei 10⁻⁵ mbar und 250°C fraktioniert sublimiert. Es verbleiben 47,7 g (32% der Theorie) als farbloser glasartiger Feststoff mit einer Reinheit von 99,9% nach HPLC.

### Verfahren B:

Verbindungen, die bei einer Sublimation Zersetzung zeigen, werden nach der Umkristallisation bei 10⁻⁵ mbar und 180°C getempert, um Reste von Lösungsmitteln und flüchtige Verunreinigungen zu entfernen.

### Verfahren C:

Für Verbindungen, die auch nach längerem Rühren mit Heptan (bis zu 24 Stunden) nicht als Feststoff oder nach Umkristallisation nicht in ausreichender Reinheit anfallen, wird eine säulenchromatographische Reinigung über Kieselgel (etwa 20 g pro Gramm Substanz) mit Toluol als Laufmittel durchgeführt. Dann wird das Lösungsmittel am Rotationsverdampfer so weit wie möglich entfernt und abschließend bei 10⁻⁵ mbar und 180°C getempert, um Reste von Lösungsmitteln und flüchtige Verunreinigungen zu entfernen.

Analog zu den beschriebenen Verfahren können folgende Verbindungen hergestellt werden:

| Beispiel | Edukt | Produkt | Verfahren Ausbeute (Reinheit HPLC) |
|---|---|---|---|
| Mo16 | Mo16.Br | 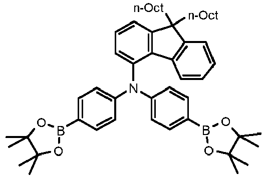 | C |
| | | | 47% |
| | | | (99.8%) |
| Mo17 | Mo12 | 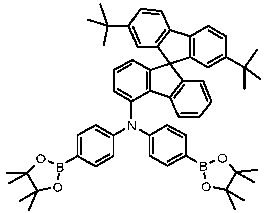 | A |
| | | | 43% |
| | | | (99.8%) |
| Mo19 | Mo19.Br | 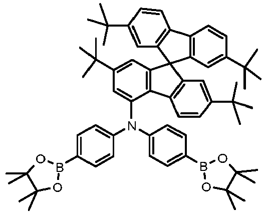 | A |
| | | | 38% |
| | | | (99.7%) |
| Mo20 | Mo20.Br | 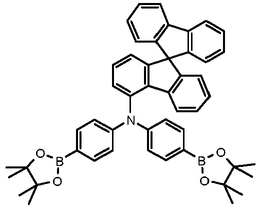 | A |
| | | | 45% |
| | | | (99.9%) |
| Mo21 | Mo21.Br | 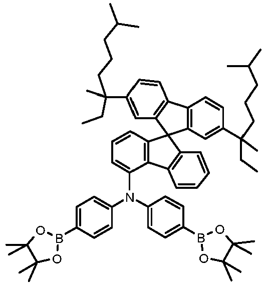 | B |
| | | | 52% |
| | | | (99.6%) |
| Mo22 | Mo22.Br | 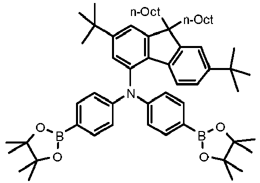 | C |
| | | | 31% |
| | | | (99.8%) |
| Mo25 | Mo24 | 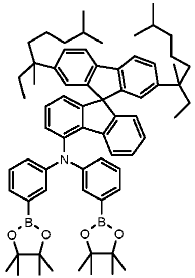 | B |
| | | | 48% |
| | | | (99.7%) |
| Mo26 | Mo26.Br | 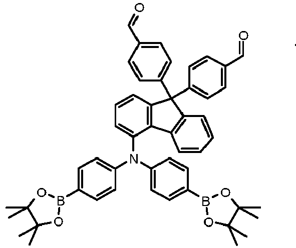 | B |
| | | | 56% |
| | | | (99.7%) |

### A2.5 Weitere Monomere

Weitere Monomere zur Herstellung der erfindungsgemäßen Polymere sind bereits im Stand der Technik beschrieben, kommerziell erhältlich oder werden gemäß Literaturvorschrift hergestellt und sind in der nachfolgenden Tabelle zusammengefaßt:

| Monomer | Struktur | Synthese gemäß |
|---|---|---|
| Mo1 | 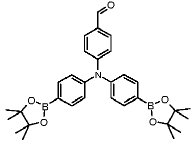 | WO 2010/097155 A1 |
| Mo2 | 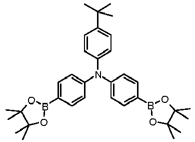 | WO 99/048160 A1 |
| Mo3 | 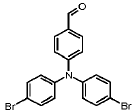 | WO 2010/097155 A1 |
| Mo4 | 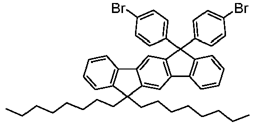 | WO 2010/136111 |
| Mo5 | 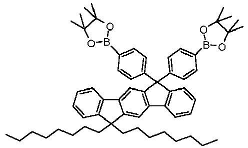 | WO 2010/136111 |
| Mo7 | 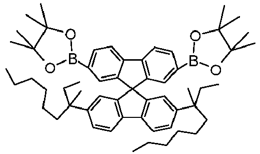 | WO 03/020790 |
| Mo8 | 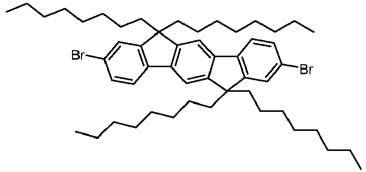 | Macromolecules 2000, 33, 2016-2020 |
| Mo9 | 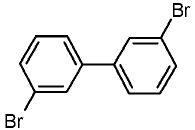 | CAS 16400-51-4 |

### Teil B: Synthese der Polymere

Herstellung der Vergleichspolymere V1 und V2 sowie der erfindungsgemäßen Polymere Po1 bis Po22.

Die Vergleichspolymere V1 und V2 sowie die erfindungsgemäßen Polymere Po1 bis Po22 werden durch SUZUKI-Kupplung gemäß dem in der WO 2010/097155 beschriebenen Verfahren aus den im Teil A offenbarten Monomeren hergestellt.

Die auf diese Weise hergestellten Polymere V1 und V2 sowie Po1 bis Po22 enthalten die Struktureinheiten nach Abspaltung der Abgangsgruppen in den in der Tabelle 2 angegebenen prozentualen Anteilen (Prozent-angaben = mol%). Bei den Polymeren, die aus Monomeren hergestellt werden, die Aldehydgruppen aufweisen, werden diese nach der Polymerisation durch WITTIG Reaktion gemäß dem in der WO 2010/097155 beschriebenen Verfahren in vernetzbare Vinylgruppen überführt. Die entsprechend in Tabelle 2 aufgeführten sowie im Teil C eingesetzten Polymere weisen somit vernetzbare Vinylgruppen anstelle der ursprünglich vorhandenen Aldehydgruppen auf.

Die Palladium- und Bromgehalte der Polymeren werden per ICP-MS bestimmt. Die ermittelten Werte liegen unter 10 ppm.

Die Molekulargewichte M_{w} sowie die Polydispersitäten D werden mittels Gelpermeationschromatographie (GPC) (Model: Agilent HPLC System Series 1100) ermittelt (Säule: PL-RapidH von Polymer Laboratories; Lösungsmittel: THF mit 0,12 Vol% o-Dichlorbenzol; Detektion: UV und Brechungsindex; Temperatur: 40°C). Kalibriert wird mit Polystyrolstandards.

Die Ergebnisse sind in Tabelle 2 zusammengefasst.

**Tabelle 2**

| Polymer | Triarylamin mit ortho Substituent | | | | | | Weitere Monomere | | | | | | Molekulargew. M_{w} (g/mol) | Polydisp. D |
|---|---|---|---|---|---|---|---|---|---|---|---|---|---|---|
| V1 | | | | | | | Mo2 | 50% | Mo8 | 50% | | | 438 000 | 3,3 |
| V2 | | | | | | | Mo2 | 40% | Mo1 | 10% | Mo8 | 50% | 417 000 | 3,1 |
| Po1 | Mo18 | 50% | | | | | Mo8 | 50% | | | | | 339 000 | 3,1 |
| Po2 | Mo18 | 40% | | | | | Mo8 | 50% | Mo1 | 10% | | | 328 000 | 2,9 |
| Po3 | Mo18 | 50% | | | | | Mo8 | 30% | Mo1 | 20% | | | 176 000 | 3,8 |
| Po4 | Mo18 | 40% | | | | | Mo6 | 50% | Mo1 | 10% | | | 123 000 | 3,3 |
| Po5 | Mo18 | 40% | | | | | Mo8 | 50% | Mo11 | 10% | | | 300 000 | 2,7 |
| Po6 | Mo18 | 49% | | | | | Mo8 | 50% | Mo2 | 1% | | | 266 000 | 2,8 |
| Po7 | Mo18 | 50% | | | | | Mo4 | 50% | | | | | 102 000 | 4,8 |
| Po8 | Mo13 | 40% | | | | | Mo5 | 50% | Mo3 | 10% | | | 20 000 | 2,0 |
| Po9 | Mo16 | 40% | | | | | Mo9 | 50% | Mo1 | 10% | | | 85 000 | 3,8 |
| Po10 | Mo16 | 40% | Mo26 | 10% | | | Mo9 | 50% | | | | | 123 000 | 3,3 |
| Po11 | Mo12 | 40% | | | | | Mo10 | 50% | Mo3 | 10% | | | 143 000 | 2,9 |
| Po12 | Mo21 | 42% | | | | | Mo4 | 50% | Mo1 | 8% | | | 154 000 | 3,1 |
| Po13 | Mo24 | 50% | Mo25 | 40% | | | Mo1 | 10% | | | | | 155 000 | 2,6 |
| Po14 | Mo23 | 40% | | | | | Mo7 | 50% | Mo3 | 10% | | | 120 000 | 3,7 |
| Po15 | Mo14 | 40% | | | | | Mo10 | 50% | Mo3 | 10% | | | 288 000 | 2,9 |
| Po16 | Mo20 | 50% | | | | | Mo8 | 50% | | | | | 403 000 | 2,2 |
| Po17 | Mo17 | 50% | | | | | Mo8 | 50% | | | | | 387 000 | 2,5 |
| Po18 | Mo21 | 50% | | | | | Mo9 | 50% | | | | | 120 000 | 3,4 |
| Po19 | Mo19 | 40% | | | | | Mo4 | 50% | Mo1 | 10% | | | 198 000 | 3,3 |
| Po20 | Mo24 | 50% | Mo21 | 35% | Mo26 | 15% | | | | | | | 131 000 | 3,1 |
| Po21 | Mo15 | 50% | Mo16 | 30% | | | Mo1 | 20% | | | | | 151 000 | 3,0 |
| Po22 | Mo22 | 50% | Mo23 | 50% | | | | | | | | | 190 000 | 3,9 |

### Teil C: Herstellung der OLEDs

Die erfindungsgemäßen Polymere können aus Lösung verarbeitet werden und führen gegenüber vakuumprozessierten OLEDs zu wesentlich einfacher herstellbaren OLEDs mit dennoch guten Eigenschaften.

Ob die vernetzbaren Varianten der erfindungsgemäßen Polymere nach Vernetzung eine vollständig unlösliche Schicht ergeben, wird analog zu WO 2010/097155 getestet.

In Tabelle C1 ist die verbliebene Schichtdicke der ursprünglich 20 nm nach dem in WO 2010/097155 beschriebenen Waschvorgang aufgeführt. Verringert sich die Schichtdicke nicht, so ist das Polymer unlöslich und somit die Vernetzung ausreichend.

**Tabelle 3:**

| Kontrolle der Restschichtdicke von ursprünglich 20 nm nach Waschtest | |
|---|---|
| Polymer | Restschichtdicke nach |
| | Waschtest [in nm] |
| | Vernetzung bei 220°C |
| V1 | 3,5 |
| V2 | 20 |
| Po02 | 20 |
| Po04 | 20 |
| Po05 | 20 |
| Po10 | 20 |

Wie Tabelle 3 zu entnehmen ist, vernetzt das Vergleichspolymer V1, das keine Vernetzungsgruppe trägt, bei 220°C fast gar nicht. Das Vergleichspolymer V2 sowie die erfindungsgemäßen Polymere Po02, Po04, Po05 und Po10 vernetzen bei 220°C vollständig.

Die Herstellung solcher lösungsbasierter OLEDs ist in der Literatur bereits vielfach beschrieben, z.B. in der WO 2004/037887 und der WO 2010/097155. Das Verfahren wird auf die im Folgenden beschriebenen Gegebenheiten (Schichtdickenvariation, Materialien) angepasst.

Die erfindungsgemäßen Polymere werden in zwei verschiedenen Schichtabfolgen verwendet:
Aufbau A ist wie folgt:
   - Substrat,
   - ITO (50 nm),
   - PEDOT (80 nm),
   - Lochtransportschicht (HTL) (20 nm),
   - Emissionsschicht (EML) (60 nm),
   - Lochblockierschicht (HBL) (10 nm)
   - Elektronentransportschicht (ETL) (40 nm),
   - Kathode.
Aufbau B ist wie folgt:
   - Substrat,
   - ITO (50 nm),
   - PEDOT (20 nm),
   - Lochtransportschicht (HTL) (40 nm),
   - Emissionsschicht (EML) (30 nm),
   - Elektronentransportschicht (ETL) (20 nm),
   - Kathode.

Als Substrat dienen Glasplättchen, die mit strukturiertem ITO (Indium-ZinnOxid) der Dicke 50 nm beschichtet sind. Zur besseren Prozessierung werden diese mit PEDOT:PSS beschichtet. Das Aufschleudern erfolgt an Luft aus Wasser. Die Schicht wird für 10 Minuten bei 180°C ausgeheizt. PEDOT:PSS wird bezogen von Heraeus Precious Metals GmbH & Co. KG, Deutschland. Auf diese beschichteten Glasplättchen werden die Lochtransport- sowie die Emissionsschicht aufgebracht.

Als Lochtransportschicht werden die erfindungsgemäßen Verbindungen sowie Vergleichsverbindungen verwendet, jeweils in Toluol gelöst. Der typische Feststoffgehalt solcher Lösungen liegt bei ca. 5 g/l, wenn, wie hier, die für eine Device typische Schichtdicken von 20 bzw. 40 nm mittels Spincoating erzielt werden soll. Die Schichten werden in einer Inertgasatmosphäre, im vorliegenden Fall Argon, aufgeschleudert und 60 Minuten bei 180°C oder 220°C ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie H1 (92%) : Dotand (8%) bedeutet hierbei, dass das Material H1 in einem Gewichtsanteil von 92% und der Dotand in einem Gewichtsanteil von 8% in der Emissionsschicht vorliegt. Die Mischung für die Emissionsschicht wird für Aufbau A in Toluol gelöst. Der typische Feststoffgehalt solcher Lösungen liegt bei ca. 18 g/l, wenn, wie hier, die für eine Device typische Schichtdicke von 60nm mittels Spincoating erzielt werden soll. Die Schichten werden in einer Inertgasatmosphäre, im vorliegenden Fall Argon, aufgeschleudert und 10 Minuten bei 180°C ausgeheizt. In Aufbau B wird die Emissionsschicht durch thermische Verdampfung in einer Vakuumkammer gebildet. Dabei kann die Schicht aus mehr als einem Material bestehen, die einander durch Co-Verdampfung in einem bestimmten Volumenanteil beigemischt werden. Eine Angabe wie H3:Dotand (95%:5%) bedeutet hierbei, dass die Materialien H3 und Dotand in einem Volumenanteil von 95%:5% in der Schicht vorliegen.

Die im vorliegenden Fall verwendeten Materialien sind in Tabelle 4 gezeigt.

**Tabelle 4:**

| | |
|---|---|
| Strukturformeln der in der Emissionsschicht verwendeten Materialien | |
| 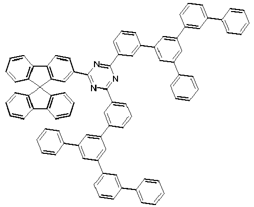 | 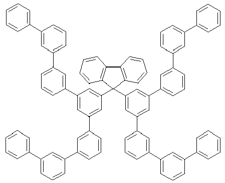 |
| H1 | H2 |
| 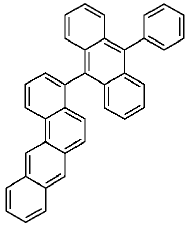 | |
| H3 | |
| 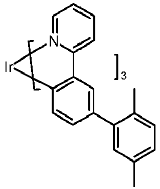 | 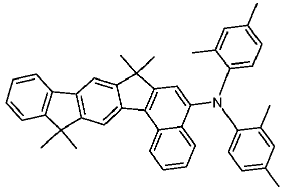 |
| TEG | SEB |

Die Materialien für die Lochblockierschicht und Elektronentransportschicht werden ebenfalls in einer Vakuumkammer thermisch aufgedampft und sind in Tabelle 5 gezeigt. Die Lochblockierschicht besteht aus ETM1. Die Elektronentransportschicht besteht aus den zwei Materialien ETM1 und ETM2, die einander durch Co-Verdampfung in einem Volumenanteil von jeweils 50% beigemischt werden.

**Tabelle 5: Verwendete HBL- und ETL-Materialien**

| | |
|---|---|
| 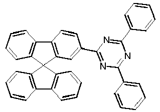 | 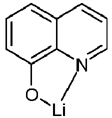 |
| ETM1 | ETM2 |

Die Kathode wird durch die thermische Verdampfung einer 100nm dicken Aluminiumschicht gebildet.

Der genaue Aufbau der OLEDs ist Tabelle 6 zu entnehmen. In der Spalte HTL wird das verwendete Polymer aufgeführt, sowie die Temperatur, bei der die Schicht ausgeheizt und ggf. vernetzt wird.

**Tabelle 6: Aufbau der OLEDs**

| Beispiel | HTL | | Aufbau | EML |
|---|---|---|---|---|
| | Polymer | T [°C] | | Zusammensetzung |
| C01 | V1 | 180°C | B | H3 95%; SEB 5% |
| C02 | V2 | 180°C | A | H1 30%; H2 55%; TEG 15% |
| C03 | Po01 | 180°C | B | H3 95%; SEB 5% |
| C04 | Po02 | 180°C | A | H1 30%; H2 55%; TEG 15% |
| C05 | Po03 | 180°C | A | H1 30%; H2 55%; TEG 15% |
| C06 | Po04 | 220°C | A | H1 30%; H2 55%; TEG 15% |
| C07 | Po05 | 220°C | A | H1 30%; H2 55%; TEG 15% |
| C08 | Po06 | 180°C | B | H3 95%; SEB 5% |
| C09 | Po07 | 180°C | B | H3 95%; SEB 5% |
| C10 | Po08 | 220°C | A | H1 30%; H2 55%; TEG 15% |
| C11 | Po09 | 220°C | A | H1 30%; H2 55%; TEG 15% |
| C12 | Po10 | 180°C | A | H1 30%; H2 55%; TEG 15% |
| C13 | Po14 | 180°C | A | H1 30%; H2 55%; TEG 15% |
| C14 | Po18 | 180°C | B | H3 95%; SEB 5% |
| C15 | Po19 | 180°C | A | H1 30%; H2 55%; TEG 15% |

Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie die (Betriebs-)Lebensdauer bestimmt. Aus den IUL-Kennlinien werden Kennzahlen bestimmt wie die Betriebsspannung (in V) und die externe Quanteneffizienz (in %) bei einer bestimmten Helligkeit. LD50 @ 1000cd/m² ist die Lebensdauer, bis die OLED bei einer Starthelligkeit von 1000 cd/m² auf 50 % der Anfangsintensität, also auf 500 cd/m², abgefallen ist. Entsprechend ist LD80 @ 10000cd/m² die Lebensdauer, bis die OLED bei einer Starthelligkeit von 10000 cd/m² auf 80 % der Anfangsintensität, also auf 8000cd/m², abgefallen ist.

Die Eigenschaften der verschiedenen OLEDs sind in den Tabellen 7 a und 7 b zusammengefasst. Die Beispiele C01 und C02 sind Vergleichsbeispiele, alle anderen Beispiele zeigen Eigenschaften von erfindungsgemäßen OLEDs.

**Tabellen 7 a und b: Eigenschaften der OLEDs**

| Tabelle 7 a | | | |
|---|---|---|---|
| Beispiel | Effizienz bei 1000 cd/m² | Spannung bei 1000 cd/m² | LD80 bei 10000 cd/m² |
| | % EQE | [V] | [h] |
| C02 | 17,0 | 4,2 | 110 |
| C04 | 16,6 | 4,8 | 250 |
| C05 | 15,3 | 4,9 | 140 |
| C06 | 15,6 | 4,8 | 190 |
| C07 | 16,5 | 4,7 | 200 |
| C10 | 20,8 | 4,9 | 220 |
| C11 | 20,2 | 4,8 | 210 |
| C12 | 20,5 | 4,9 | 260 |
| C13 | 17,5 | 4,5 | 220 |
| C15 | 20,2 | 4,8 | 190 |

| Tabelle 7 b | | | |
|---|---|---|---|
| Beispiel | Effizienz bei 1000 cd/m² | Spannung bei 1000 cd/m² | LD50 bei 1000 cd/m² |
| | % EQE | [V] | [h] |
| C01 | 4,9 | 4,5 | 380 |
| C03 | 5,2 | 4,0 | 2100 |
| C08 | 5,9 | 4,4 | 3200 |
| C09 | 9,5 | 4,3 | 1400 |
| C14 | 7,8 | 4,4 | 1800 |

Wie die Tabellen 7 a und b zeigen, ergeben die erfindungsgemäßen Polymere bei Einsatz als Lochtransportschicht in OLEDs Verbesserungen gegenüber dem Stand der Technik, vor allem bezüglich Lebensdauer und operativer Spannung. Es werden grün und blau emittierende OLEDs mit den erfindungsgemäßen Materialien erzeugt.

## Patentansprüche

1. Polymer, das mindestens eine Struktureinheit der folgenden Formel (la) aufweist: 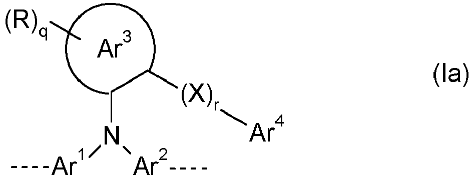 wobei
Ar¹ und Ar² bei jedem Auftreten, jeweils gleich oder verschieden, ein mono- oder polycyclisches, aromatisches oder heteroaromatisches Ringsystem mit 5 bis 60 aromatischen Ringatomen ist, das mit einem oder mehreren Resten R substituiert sein kann;
Ar³ ein mono- oder polycyclisches, aromatisches Ringsystem mit 5 bis 60 aromatischen Ringatomen ist, das mit einem oder mehreren Resten R substituiert sein kann;
R bei jedem Auftreten gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein mono- oder polycyclisches, aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, oder eine vernetzbare Gruppe Q, ist, wobei zwei oder mehrere Reste R auch miteinander ein mono- oder polycyclisches, aliphatisches, aromatisches und/oder benzoannelliertes Ringsystem bilden können;
R¹ bei jedem Auftreten gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches oder aromatisches Ringsystem bilden können;
q 0, 1, 2, 3, 4, 5 oder 6 ist;
X CR₂, SiR₂, O, S, C=O oder P=O ist;
r 0 oder 1 ist; und
die gestrichelten Linien Bindungen zu benachbarten Struktureinheiten im Polymer darstellen;
**dadurch gekennzeichnet, dass** Ar³ in mindestens einer der beiden ortho-Positionen, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann,
mit der Maßgabe, dass die Polymere P19a, P19b, P20a, P20b, P22a, P22b, P33a, P33b, P41a und P41b der WO 2013/156125 A1 ausgeschlossen sind.

2. Polymer nach Anspruch 1, **dadurch gekennzeichnet, dass** Ar³ in einer der beiden ortho-Positionen mit Ar⁴ substituiert ist, und Ar³ mit Ar⁴ zusätzlich noch in der zur substituierten ortho-Position benachbarten meta-Position verknüpft ist.

3. Polymer nach Anspruch 1 oder 2, **dadurch gekennzeichnet, dass** die mindestens eine Struktureinheit der Formel (la) ausgewählt ist aus der Struktureinheit der folgenden Formel (Ib): 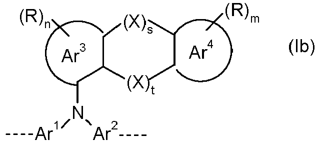
wobei Ar¹, Ar², Ar³, Ar⁴, R, und X die im Anspruch 1 angegebenen Bedeutungen annehmen können,
m = 0, 1, 2, 3 oder 4 ist, und
n = 0, 1, 2 oder 3 ist, und
s und t jeweils 0 oder 1 sind, wobei die Summe (s + t) = 1 oder 2, ist.

4. Polymer nach einem oder mehreren der Ansprüche 1 bis 3, **dadurch gekennzeichnet, dass** die mindestens eine Struktureinheit der Formel (la) ausgewählt ist aus Struktureinheiten der folgenden Formeln (II), (III) und (IV): 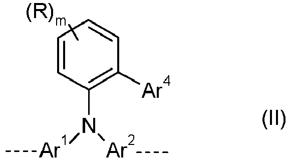 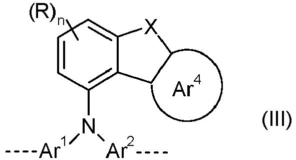 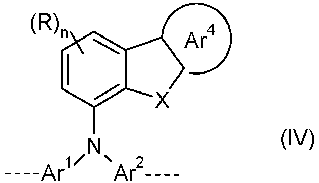 wobei Ar¹, Ar², Ar⁴, R, m, n und X die in den Ansprüchen 1 und 3 angegebenen Bedeutungen annehmen können.

5. Polymer nach Anspruch 4, **dadurch gekennzeichnet, dass** die mindestens eine Struktureinheit der Formel (II) ausgewählt ist aus der Struktureinheit der folgenden Formel (V): 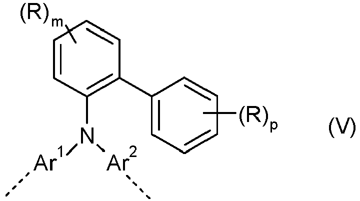
wobei Ar¹, Ar², R und m die im Anspruch 1 angegebenen Bedeutungen annehmen können, und
p = 0, 1, 2, 3, 4 oder 5 ist.

6. Polymer nach Anspruch 4, **dadurch gekennzeichnet, dass** die mindestens eine Struktureinheit der Formel (III) ausgewählt ist aus der Struktureinheit der folgenden Formel (VI): 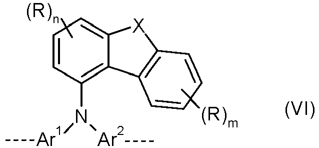 wobei Ar¹, Ar², R, m und n die in den Ansprüchen 1 und 3 angegebenen Bedeutungen annehmen können.

7. Polymer nach Anspruch 4, **dadurch gekennzeichnet, dass** die mindestens eine Struktureinheit der Formel (IV) ausgewählt ist aus der Struktureinheit der folgenden Formel (VII): 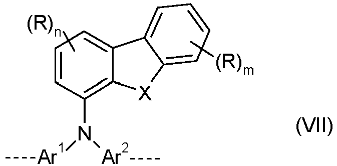 wobei Ar¹, Ar², R, m, n und X die in den Ansprüchen 1 und 3 angegebenen Bedeutungen annehmen können.

8. Polymer nach einem oder mehreren der Ansprüche 1 bis 7, **dadurch gekennzeichnet, dass** der Anteil an Struktureinheiten der Formel (la), (II), (III), (IV), (V), (VI) oder (VII) im Polymer im Bereich von 50 bis 95 mol% liegt, bezogen auf 100 mol% aller copolymerisierbaren Monomere, die im Polymer als Struktureinheiten enthalten sind.

9. Polymer nach einem oder mehreren der Ansprüche 1 bis 8, **dadurch gekennzeichnet, dass** das Polymer neben Struktureinheiten der Formel (la), (II), (III), (IV), (V), (VI) oder (VII) noch weitere, von den Struktureinheiten der Formeln (la), (II), (III), (IV), (V), (VI) oder (VII) verschiedene Struktureinheiten aufweist.

10. Verfahren zur Herstellung eines Polymeren nach einem oder mehreren der Ansprüche 1 bis 9, **dadurch gekennzeichnet, dass** es durch Polymerisation gemäß SUZUKI, Polymerisation gemäß YAMAMOTO, Polymerisation gemäß STILLE oder Polymerisation gemäß HARTWIG-BUCHWALD hergestellt wird.

11. Polymer Blend enthaltend ein oder mehrere Polymere nach einem oder mehreren der Ansprüche 1 bis 9, welche mindestens eine Struktureinheit der Formel (Ia) enthalten, sowie eine oder mehrere weitere polymere, oligomere, dendritische und/oder niedermolekulare Substanzen.

12. Lösungen oder Formulierungen aus einem oder mehreren Polymeren nach einem oder mehreren der Ansprüche 1 bis 9 oder einem Polymer Blend nach Anspruch 11 in einem oder mehreren Lösungsmitteln.

13. Verwendung eines Polymeren nach einem oder mehreren der Ansprüche 1 bis 9 in elektronischen oder optoelektronischen Vorrichtungen.

14. Elektronische oder optoelektronische Vorrichtung mit einer oder mehreren aktiven Schichten, wobei mindestens eine dieser aktiven Schichten ein oder mehrere Polymere nach einem oder mehreren der Ansprüche 1 bis 9 enthält.

## Claims

1. Polymer which contains at least one structural unit of the following formula (Ia): 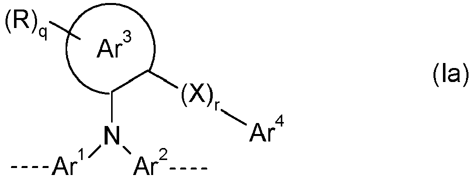 where
Ar¹ and Ar² are on each occurrence, in each case identically or differently, a mono- or polycyclic, aromatic or heteroaromatic ring system having 5 to 60 aromatic ring atoms, which may be substituted by one or more radicals R;
Ar³ is a mono- or polycyclic, aromatic ring system having 5 to 60 aromatic ring atoms, which may be substituted by one or more radicals R;
R is on each occurrence, identically or differently, H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 40 C atoms or a branched or cyclic alkyl, alkoxy or thioalkoxy group having 3 to 40 C atoms, which may in each case be substituted by one or more radicals R¹, where one or more non-adjacent CH₂ groups may be replaced by R¹C=CR¹, C≡C, Si(R¹)₂, C=O, C=S, C=NR¹, P(=O)(R'), SO, SO₂, NR¹, O, S or CONR¹ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, or an aralkyl or heteroaralkyl group having 5 to 60 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹, or a crosslinkable group Q, where two or more radicals R may also form a mono- or polycyclic, aliphatic, aromatic and/or benzofused ring system with one another;
R¹ is on each occurrence, identically or differently, H, D, F or an aliphatic hydrocarbon radical having 1 to 20 C atoms, an aromatic and/or a heteroaromatic hydrocarbon radical having 5 to 20 C atoms, in which, in addition, one or more H atoms may be replaced by F; where two or more substituents R¹ may also form a mono- or polycyclic, aliphatic or aromatic ring system with one another;
Q is 0, 1, 2, 3, 4, 5 or 6;
X is CR₂, SiR₂, O, S, C=O or P=O;
R is 0 or 1; and
the dashed lines represent bonds to adjacent structural units in the polymer,
**characterised in that** Ar³ is substituted by Ar⁴ in at least one of the two ortho positions, where Ar⁴ is a mono- or polycyclic, aromatic or heteroaromatic ring system having 5 to 60 aromatic ring atoms, which may be substituted by one or more radicals R,
with the proviso that the polymers P19a, P19b, P20a, P20b, P22a, P22b, P33a, P33b, P41a and P41b from WO 2013/156125 A1 are excluded.

2. Polymer according to Claim 1, **characterised in that** Ar³ is substituted by Ar⁴ in one of the two ortho positions, and Ar³ is additionally linked to Ar⁴ in the meta position adjacent to the substituted ortho position.

3. Polymer according to Claim 1 or 2, **characterised in that** the at least one structural unit of the formula (Ia) is selected from the structural unit of the following formula (Ib): 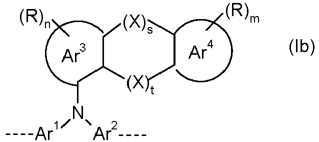
where Ar¹, Ar², Ar³, Ar⁴, R and X can adopt the meanings indicated in Claim 1,
m = 0, 1, 2, 3 or 4, and
n = 0, 1, 2 or 3, and
s and t are each 0 or 1, where the sum (s + t) = 1 or 2.

4. Polymer according to one or more of Claims 1 to 3, **characterised in that** the at least one structural unit of the formula (Ia) is selected from structural units of the following formulae (II), (III) and (IV): 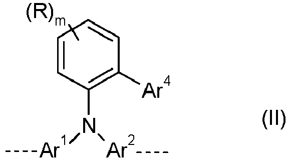 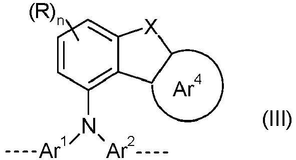 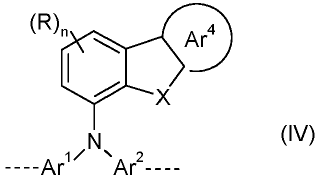 where Ar¹, Ar², Ar⁴, R, m, n and X can adopt the meanings indicated in Claims 1 and 3.

5. Polymer according to Claim 4, **characterised in that** the at least one structural unit of the formula (II) is selected from the structural unit of the following formula (V): 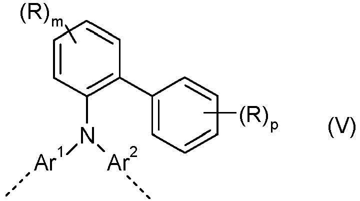
where Ar¹, Ar², R and m can adopt the meanings indicated in Claim 1, and
p = 0, 1, 2, 3, 4 or 5.

6. Polymer according to Claim 4, **characterised in that** the at least one structural unit of the formula (III) is selected from the structural unit of the following formula (VI): 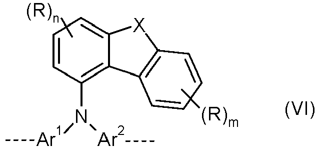 where Ar¹, Ar², R, m and n can adopt the meanings indicated in Claims 1 and 3.

7. Polymer according to Claim 4, **characterised in that** the at least one structural unit of the formula (IV) is selected from the structural unit of the following formula (VII): 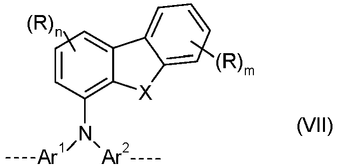 where Ar¹, Ar², R, m, n and X can adopt the meanings indicated in Claims 1 and 3.

8. Polymer according to one or more of Claims 1 to 7, **characterised in that** the proportion of structural units of the formula (Ia), (II), (III), (IV), (V), (VI) or (VII) in the polymer is in the range from 50 to 95 mol%, based on 100 mol% of all copolymerisable monomers which are present as structural units in the polymer.

9. Polymer according to one or more of Claims 1 to 8, **characterised in that** the polymer, besides structural units of the formula (Ia), (II), (III), (IV), (V), (VI) or (VII), also contains further structural units which are different from the structural units of the formulae (Ia), (II), (III), (IV), (V), (VI) or (VII).

10. Process for the preparation of a polymer according to one or more of Claims 1 to 9, **characterised in that** it is prepared by SUZUKI polymerisation, YAMAMOTO polymerisation, STILLE polymerisation or HARTWIG-BUCHWALD polymerisation.

11. Polymer blend comprising one or more polymers according to one or more of Claims 1 to 9 which contain at least one structural unit of the formula (Ia), and one or more further polymeric, oligomeric, dendritic and/or low-molecular-weight substances.

12. Solutions or formulations comprising one or more polymers according to one or more of Claims 1 to 9 or a polymer blend according to Claim 11 in one or more solvents.

13. Use of a polymer according to one or more of Claims 1 to 9 in electronic or opto-electronic devices.

14. Electronic or opto-electronic device having one or more active layers, where at least one of these active layers comprises one or more polymers according to one or more of Claims 1 to 9.

## Revendications

1. Polymère qui contient au moins un motif structurel de formule (la) suivante : 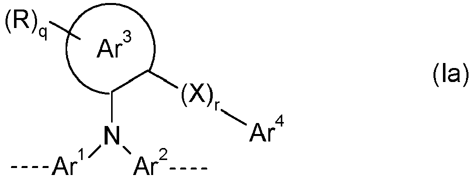 dans laquelle
Ar¹ et Ar² sont à chaque occurrence, dans chaque cas de manière identique ou différente, un noyau aromatique ou hétéroaromatique, mono- ou polycyclique, ayant de 5 à 60 atomes de cycle aromatique, pouvant être substitué par un ou plusieurs radicaux R ;
Ar³ est un noyau aromatique, mono- ou polycyclique, ayant de 5 à 60 atomes de cycle aromatique, pouvant être substitué par un ou plusieurs radicaux R ;
R est à chaque occurrence, de manière identique ou différente, H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, un groupement alkyle, alcoxy ou thioalcoxy à chaîne linéaire ayant de 1 à 40 atomes de C ou un groupement alkyle, alcoxy ou thioalcoxy ramifié ou cyclique ayant de 3 à 40 atomes de C, pouvant dans chaque cas être substitué par un ou plusieurs radicaux R¹, où un ou plusieurs groupements CH₂ non adjacents peuvent être remplacés par R¹C=CR¹, C=C, Si(R¹)₂, C=O, C=S, C=NR¹, P(=O)(R'), SO, SO₂, NR¹, O, S ou CONR¹ et où un ou plusieurs atomes de H peuvent être remplacés par D, F, Cl, Br, I ou CN, ou un noyau aromatique ou hétéroaromatique, mono- ou polycyclique, ayant de 5 à 60 atomes de cycle aromatique, pouvant dans chaque cas être substitué par un ou plusieurs radicaux R¹, ou un groupement aryloxy ou hétéroaryloxy ayant de 5 à 60 atomes de cycle aromatique, pouvant être substitué par un ou plusieurs radicaux R¹, ou un groupement aralkyle ou hétéroaralkyle ayant de 5 à 60 atomes de cycle aromatique, pouvant être substitué par un ou plusieurs radicaux R¹, ou un groupement diarylamino, un groupement dihétéroarylamino ou un groupement arylhétéroarylamino ayant de 10 à 40 atomes de cycle aromatique, pouvant être substitué par un ou plusieurs radicaux R¹, ou un groupement réticulable Q, où deux, ou plus, radicaux R peuvent également former un noyau mono- ou polycyclique, aliphatique, aromatique et/ou benzo-condensé les uns avec les autres ;
R¹ est à chaque occurrence, de manière identique ou différente, H, D, F ou un radical hydrocarboné aliphatique ayant de 1 à 20 atomes de C, un radical hydrocarboné aromatique et/ou hétéroaromatique ayant de 5 à 20 atomes de C, où, de plus, un ou plusieurs atomes de H peuvent être remplacés par F ; où deux, ou plus, substituants R¹ peuvent également former un noyau aliphatique ou aromatique, mono- ou polycyclique, les uns avec les autres ;
Q vaut 0, 1, 2, 3, 4, 5 ou 6 ;
X est CR₂, SiR₂, O, S, C=O ou P=O ;
R vaut 0 ou 1 ; et
les lignes en pointillés représentent des liaisons aux motifs structurels adjacents dans le polymère,
**caractérisé en ce que** Ar³ est substitué par Ar⁴ dans au moins l'une des deux positions ortho, où Ar⁴ est un noyau aromatique ou hétéroaromatique, mono- ou polycyclique, ayant de 5 à 60 atomes de cycle aromatique, pouvant être substitué par un ou plusieurs radicaux R,
à condition que les polymères P19a, P19b, P20a, P20b, P22a, P22b, P33a, P33b, P41a et P41b du document WO 2013/156125 A1 soient exclus.

2. Polymère selon la revendication 1, **caractérisé en ce que** Ar³ est substitué par Ar⁴ dans l'une des deux positions ortho, et Ar³ est en outre lié à Ar⁴ en position méta adjacente à la position ortho substituée.

3. Polymère selon la revendication 1 ou 2, **caractérisé en ce que** le au moins un motif structurel de formule (la) est choisi parmi le motif structurel de formule (Ib) suivante : 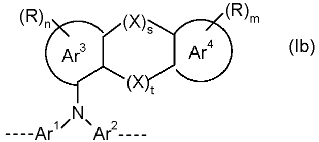
dans laquelle Ar¹, Ar², Ar³, Ar⁴, R et X peuvent adopter les significations indiquées selon la revendication 1,
m = 0, 1, 2, 3 ou 4, et
n = 0, 1, 2 ou 3, et
s et t valent chacun 0 ou 1, où la somme (s + t) = 1 ou 2.

4. Polymère selon l'une ou plusieurs parmi les revendications 1 à 3, **caractérisé en ce que** le au moins un motif structurel de formule (la) est choisi parmi les motifs structurels de formules (II), (III) et (IV) suivantes : 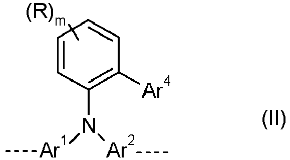 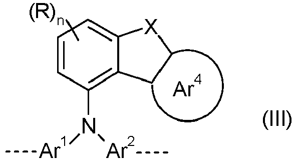 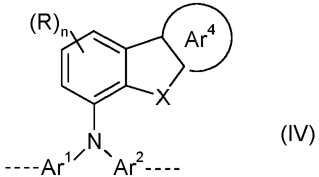 dans lesquelles Ar¹, Ar², Ar⁴, R, m, n et X peuvent adopter les significations indiquées selon la revendications 1 et 3.

5. Polymère selon la revendication 4, **caractérisé en ce que** le au moins un motif structurel de formule (II) est choisi parmi le motif structurel de formule (V) suivante : 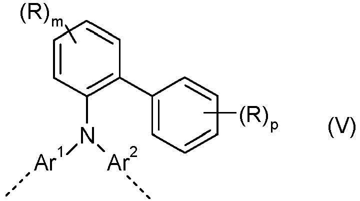
dans laquelle Ar¹, Ar², R et m peuvent adopter les significations indiquées selon la revendication 1, et
p = 0, 1, 2, 3, 4 ou 5.

6. Polymère selon la revendication 4, **caractérisé en ce que** le au moins un motif structurel de formule (III) est choisi parmi le motif structurel de formule (VI) suivante : 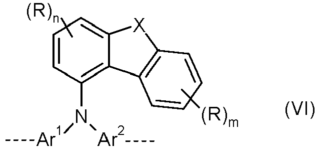 dans laquelle Ar¹, Ar², R, m et n peuvent adopter les significations indiquées selon la revendications 1 et 3.

7. Polymère selon la revendication 4, **caractérisé en ce que** le au moins un motif structurel de formule (IV) est choisi parmi le motif structurel de formule (VII) suivante : 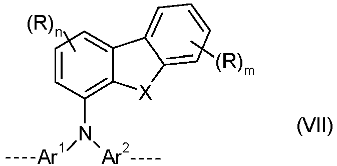 dans laquelle Ar¹, Ar², R, m, n et X peuvent adopter les significations indiquées selon la revendications 1 et 3.

8. Polymère selon l'une ou plusieurs parmi les revendications 1 à 7, **caractérisé en ce que** la proportion de motifs structurels de formule (la), (II), (III), (IV), (V), (VI) ou (VII) dans le polymère se trouve dans la plage allant de 50 à 95% molaire, sur la base de 100% molaire de tous les monomères copolymérisables qui sont présents comme motifs structurels dans le polymère.

9. Polymère selon l'une ou plusieurs parmi les revendications 1 à 8, **caractérisé en ce que** le polymère, outre les motifs structurels de formule (Ia), (II), (III), (IV), (V), (VI) ou (VII), contient également d'autres motifs structurels qui sont différents des motifs structurels de formules (Ia), (II), (III), (IV), (V), (VI) ou (VII).

10. Procédé de préparation d'un polymère selon l'une ou plusieurs parmi les revendications 1 à 9, **caractérisé en ce qu'**il est préparé par polymérisation de SUZUKI, polymérisation de YAMAMOTO, polymérisation de STILLE ou polymérisation de HARTWIG-BUCHWALD.

11. Mélange de polymères comprenant un ou plusieurs polymères selon l'une ou plusieurs parmi les revendications 1 à 9, qui contiennent au moins un motif structurel de formule (Ia), et un ou plusieurs autres substances polymères, oligomères, dendritiques et/ou de bas poids moléculaire.

12. Solutions ou formulations comprenant un ou plusieurs polymères selon l'une ou plusieurs parmi les revendications 1 à 9, ou un mélange de polymères selon la revendication 11, dans un ou plusieurs solvants.

13. Utilisation d'un polymère selon l'une ou plusieurs parmi les revendications 1 à 9, dans des dispositifs électroniques ou opto-électroniques.

14. Dispositif électronique ou opto-électronique ayant une ou plusieurs couches actives, dans lequel au moins l'une parmi ces couches actives comprend un ou plusieurs polymères selon l'une ou plusieurs parmi les revendications 1 à 9.
